**Europäisches Patentamt**

**European Patent Office**

**Office européen des brevets**

(19)

(11) Numéro de publication: **0 136 237**
**B1**

(12)

# FASCICULE DE BREVET EUROPEEN

(45) Date de publication du fascicule du brevet:
**03.06.87**

(51) Int. Cl.⁴: **H 05 K 7/10**

(21) Numéro de dépôt: **84401898.6**

(22) Date de dépôt: **21.09.84**

(54) **Support de boîtier de circuit intégré.**

(30) Priorité: **23.09.83 FR 8315150**

(43) Date de publication de la demande:
**03.04.85 Bulletin 85/14**

(45) Mention de la délivrance du brevet:
**03.06.87 Bulletin 87/23**

(84) Etats contractants désignés:
**DE FR GB**

(56) Documents cités:
**WO - A - 82/04359**
**GB - A - 2 080 637**
**US - A - 2 748 328**
**US - A - 3 289 045**
**US - A - 3 880 493**

(73) Titulaire: **Nalbanti, Georges, 68, avenue de la Tournaisis**
**Elancourt, F-78130 Maurepas (FR)**

(72) Inventeur: **Nalbanti, Georges, 68, avenue de la**
**Tournaisis Elancourt, F-78130 Maurepas (FR)**

(74) Mandataire: **Martinet & Lapoux, 62, rue des Mathurins,**
**F-75008 Paris (FR)**

## Description

1. La présente invention concerne un support de boîtier de circuit intégré comprenant des broches conductrices, sous-jacentes au support, dans lesquelles s'enfichent des broches conductrices du boîtier; cf. par exemple le US-A-3 880 493.

L'invention a trait plus particulièrement à la sauvegarde d'informations binaires dans un circuit intégré, telle qu'une mémoire, lorsque la puissance fournie par une source d'alimentation principale d'une carte de circuit imprimé sur laquelle est implanté le support, disparaît pour une cause quelconque. Une source d'alimentation de secours doit être prévue pour se substituer à la source d'alimentation principale afin de conserver le contenu de la mémoire, ou bien au moins une fonction logique essentielle effectuée par le circuit intégré, telle que la génération d'un signal d'horloge.

Deux solutions d'implantation d'une source d'alimentation de secours pour circuit intégré ont déjà été proposées. La source de secours est constituée généralement de plusieurs piles ou accumulateurs miniatures.

Selon une première solution, la source d'alimentation de secours est enfermée dans un boîtier plat cylindrique ou parallélépipédique, directement implanté sur la carte de circuit imprimé. Le boîtier de la source d'alimentation de secours occupe une place non négligeable sur la carte de circuit imprimé et diminue ainsi le nombre de circuits intégrés susceptibles d'être implantés sur la carte. En outre, des conducteurs imprimés supplémentaires sont nécessaires pour relier la source d'alimentation de secours aux bornes d'alimentation du circuit intégré.

Une seconde solution consiste à enfermer la source d'alimentation de secours dans le boîtier de circuit intégré. Le coût du circuit intégré est alors élevé. Si le circuit intégré ou la source d'alimentation de secours est défectueux, l'ensemble du boîtier doit être remplacé, la source de secours n'étant pas seule accessible.

Selon une variante de la seconde solution divulguée par la demande de brevet international WO-A-8 204 359, la source d'alimentation de secours est encastrée d'une manière amovible dans une cavité ouverte pratiquée dans une grande face supérieure du boîtier de circuit intégré à l'opposé de la carte de circuit imprimé. Un tel boîtier doit être conçu pour chaque circuit intégré spécifique et le remplacement du module de circuit intégré nécessite le remplacement de l'ensemble du boîtier.

La présente invention a pour but d'obvier aux inconvénients des implantations des sources d'alimentation de secours selon la technique antérieure, notamment en permettant un remplacement aisé et peu onéreux d'une source d'alimentation de secours pour boîtier standard de circuit intégré sans sensible augmentation de la place déjà prévue pour l'implantation du boîtier de circuit intégré sur une carte de circuit imprimé.

A ces fins, un support de boîtier de circuit intégré est tel caractérisé dans la revendication 1. L'invention utilise ainsi l'espace disponible entre un boîtier de circuit intégré et la carte de circuit imprimé pour y introduire un support selon l'invention ayant des dimensions analogues à celles du boîtier mais incluant une source d'alimentation de secours. La hauteur de l'ensemble boîtier et support demeure pratiquement faible grâce à l'emploi de piles ou accumulateurs miniatures du type bouton, en tant que source d'alimentation de secours, déjà utilisés par ailleurs pour des calculatrices, des montres ou des jeux électroniques. Le coût de l'adjonction de la source de secours est d'autant plus réduit que la source de secours fait appel à des piles ou accumulateurs ayant une grande diffusion. De plus, la source de secours est amovible du support, ce qui ne nécessite pas un remplacement complet du support ou du boîtier de circuit intégré lorsque la source de secours est défectueuse.

Selon d'autres caractéristiques définies dans les revendications 17 à 24, un couvercle amovible du support est intercalé entre le boîtier de circuit intégré et le support. Le couvercle est moulé en une matière plastique souple. Il est combiné à des moyens de verrouillage afin de verrouiller le couvercle et le support pour maintenir la source de secours dans le support en l'absence du boîtier d'une part, et de verrouiller le boîtier et le support pour connecter rigidement sans soudure les broches du boîtier à celles du support. Une opération de déverrouillage du boîtier et du support peut être effectuée sans déverrouiller le couvercle du support afin de retirer le boîtier, lorsque par exemple celui est défectueux, et de maintenir la source de secours dans le support. Toutes ces opérations peuvent être effectuées simplement par de simples pressions exercées sur le couvercle et le boîtier.

Selon une autre caractéristique de l'invention, le support contient des moyens de surveillance pour détecter une tension aux bornes de la source d'alimentation de secours inférieure à un seuil de décharge prédéterminé. Les moyens de surveillance signalent, visuellement et/ou acoustiquement, le début de la décharge de la source de secours en vue de remplacer la source de secours et de conserver la fonction ou le contenu du circuit intégré.

Selon une autre caractéristique de l'invention, le support contient des moyens pour inhiber une fonction prédéterminée du circuit intégré lorsque la tension de la source d'alimentation principale entre lesdites broches d'alimentation disparaît. Lorsque le circuit intégré est une mémoire, la fonction à inhiber peut être une autorisation d'écriture dans la mémoire.

D'autre caractéristiques et avantages de la présente invention apparaîtront plus clairement à la lecture de la description suivant de plusieurs modes de réalisation du support selon l'invention en référence aux dessins annexés correspondants dans lesquels:

la Fig. 1 est une vue en perspective éclatée d'un support de boîtier de circuit intégré selon l'invention, comprenant deux piles boutons de secours tête-bêche et juxtaposées ayant des axes perpendiculaires aux grandes faces du boîtier;

la Fig. 2 est une vue transversale schématique du support de la Fig. 1 implantée sur une carte de circuit imprimé;

la Fig. 3 est une vue de dessus schématique de deux supports selon la Fig. 1 alimentés par une source d'alimentation principale de la carte de circuit imprimé;

la Fig. 4 est une vue de dessus schématique d'un ensemble de trois supports selon l'invention dont un est destiné à secourir les autres;

la Fig. 5 est une vue en perspective détaillée d'un support à droite dans la Fig. 4 au niveau de l'une des pistes de continuité d'alimentation du support;

la Fig. 6 est une vue en coupe transversale schématique d'un support selon l'invention ayant une cavité moulée pour recevoir une source d'alimentation de secours;

la Fig. 7 est une vue en perspective partielle d'un support selon l'invention ayant une cavité fermée hermétiquement par un couvercle et recevant deux piles boutons de secours;

la Fig. 8 est une vue en perspective schématique du logement d'un support selon l'invention pour recevoir deux piles boutons tête-bêche et juxtaposées ayant des axes parallèles aux grandes faces de boîtier de circuit intégré;

la Fig. 9 est une vue en perspective schématique du support selon la Fig. 8, muni d'un couvercle fermant le logement;

la Fig. 10 est une vue en perspective éclatée d'un support de boîtier de circuit intégré selon l'invention, contenant trois piles boutons de secours juxtaposées, le support étant assemblé à un couvercle amovible pour connecter et déconnecter sans soudure les broches du circuit intégré aux broches du support, suite à des pressions exercées sur le boîtier;

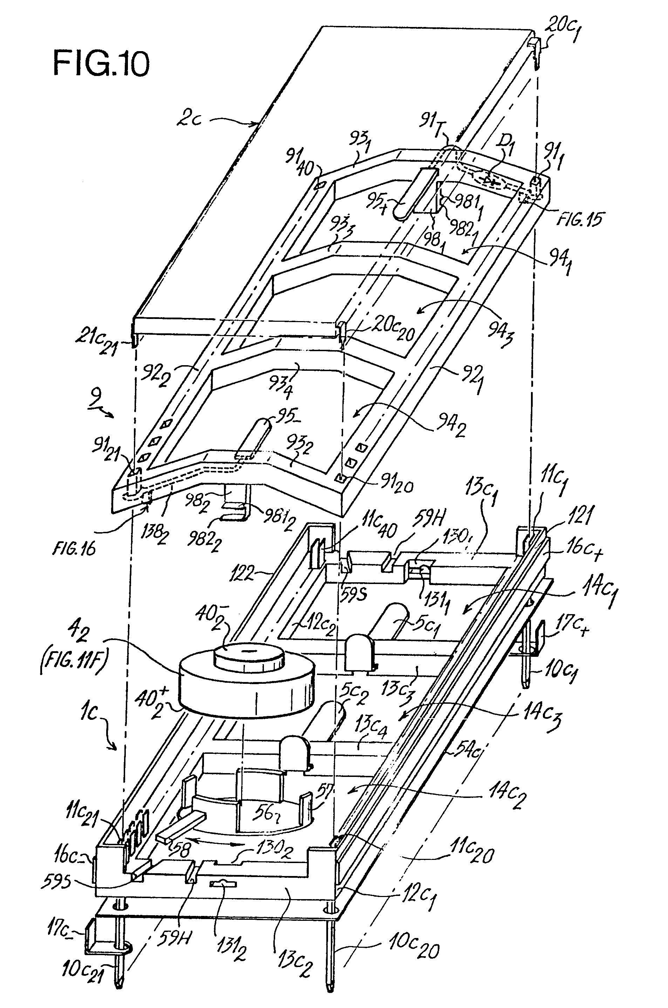

les Figs, 11A à 11H montrent schématiquement diverses dispositions de piles dans des supports à deux ou trois logements de piles, munis chacun d'un interrupteur de source d'alimentation de secours montré à la Fig. 10, respectivement;

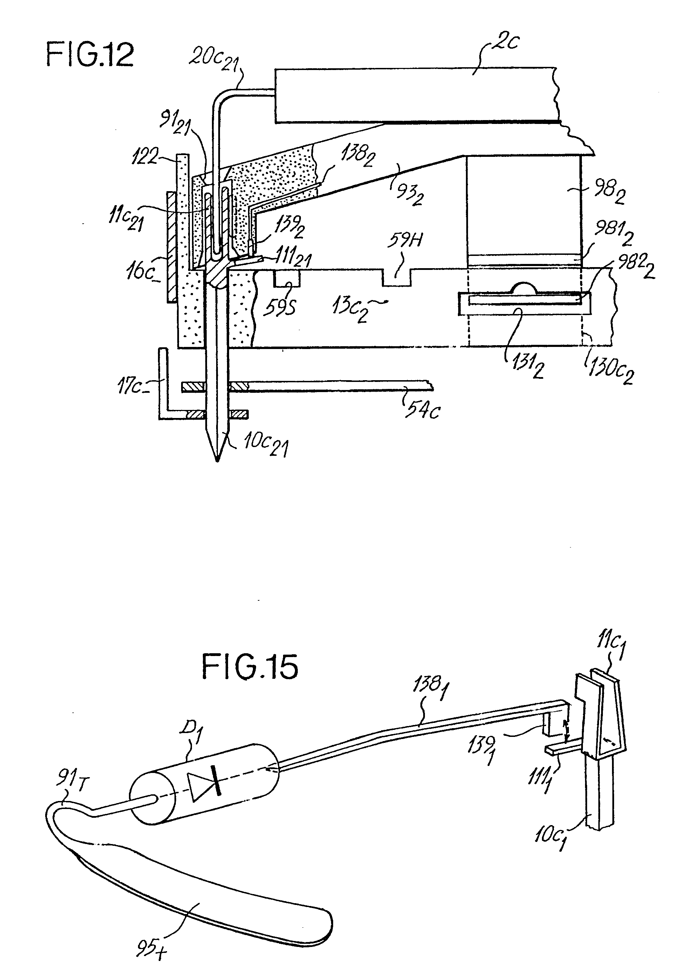

la Fig. 12 est une vue latérale détaillée partiellement en coupe du support et du couvercle selon la Fig. 10, au niveau d'une broche d'alimentation du support, après verrouillage du couvercle et du support par des premiers moyens de verrouillage, et avant verrouillage du boîtier de circuit intégré du support;

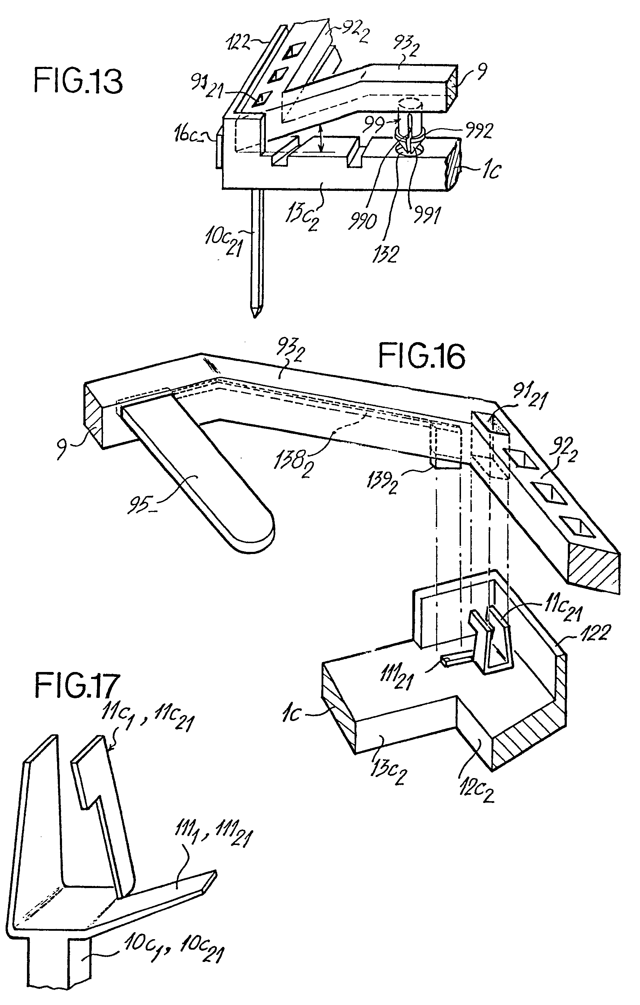

la Fig. 13, est une vue en perspective de seconds moyens de verrouillage du couvercle et du support selon la Fig. 10;

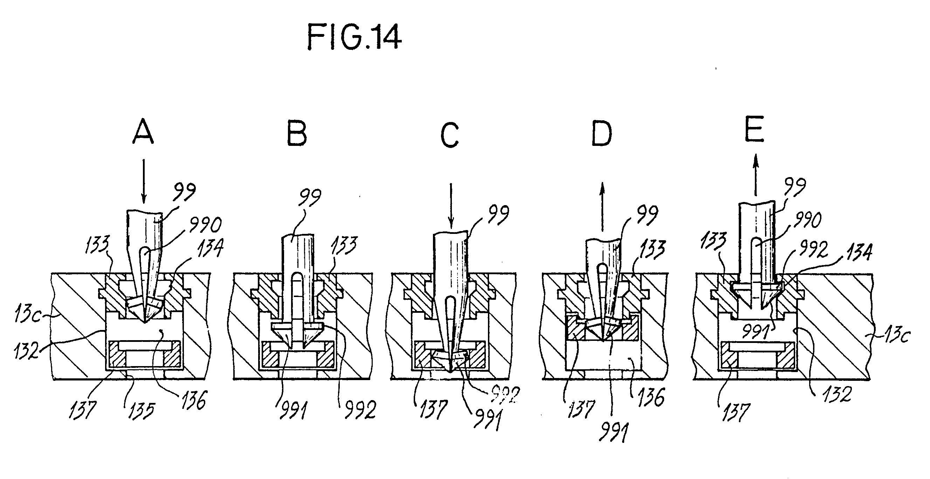

les Figs. 14A à 14E sont des vues en coupe des seconds moyens de verrouillage à différentes étapes de verrouillage du couvercle et du boîtier et de déverrouillage du boîtier par rapport au support, respectivement;

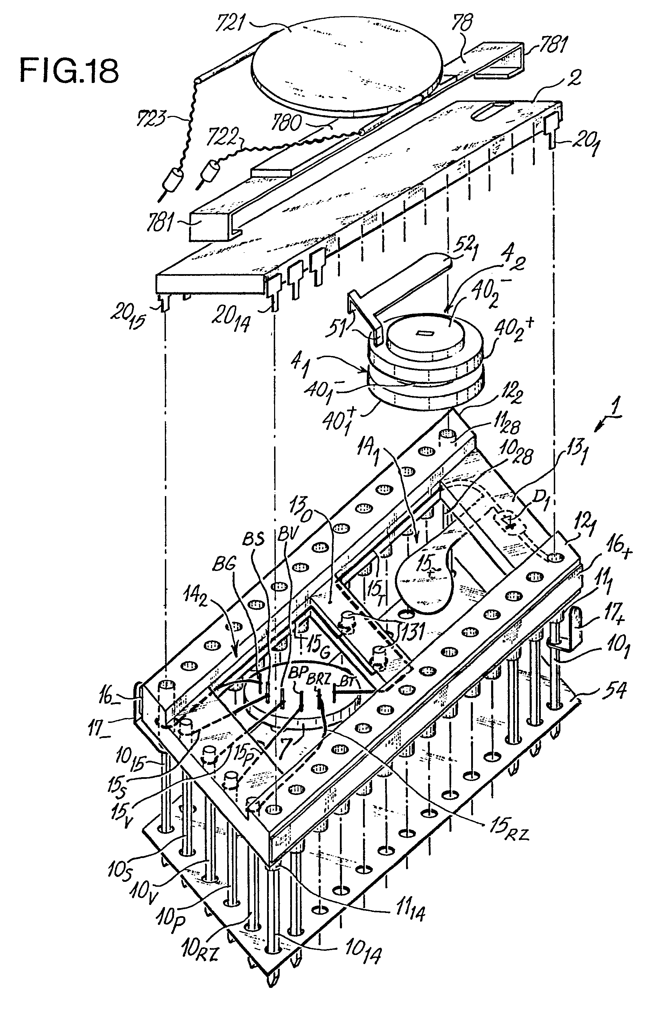

la Fig. 15 est une vue en perspective schématique d'une liaison électrique entre une lame de liaison à une pile et une broche d'alimentation positive du support selon la Fig. 10;

la Fig. 16 est une vue en perspective éclatée schématique d'une liaison électrique entre une autre lame de liaison à une autre pile et une broche d'alimentation négative du support selon la Fig. 10;

la Fig. 17 est une vue en perspective d'un fourreau particulier d'une broche d'alimentation;

la Fig. 18 est une vue en perspective éclatée d'un support de boîtier de circuit intégré selon l'invention, comprenant deux piles boutons de secours superposées parallèlement aux grandes faces du boîtier, ainsi qu'un boîtier contenant un circuit de surveillance de tension des piles de secours et/ou un circuit d'inhibition de fonction;

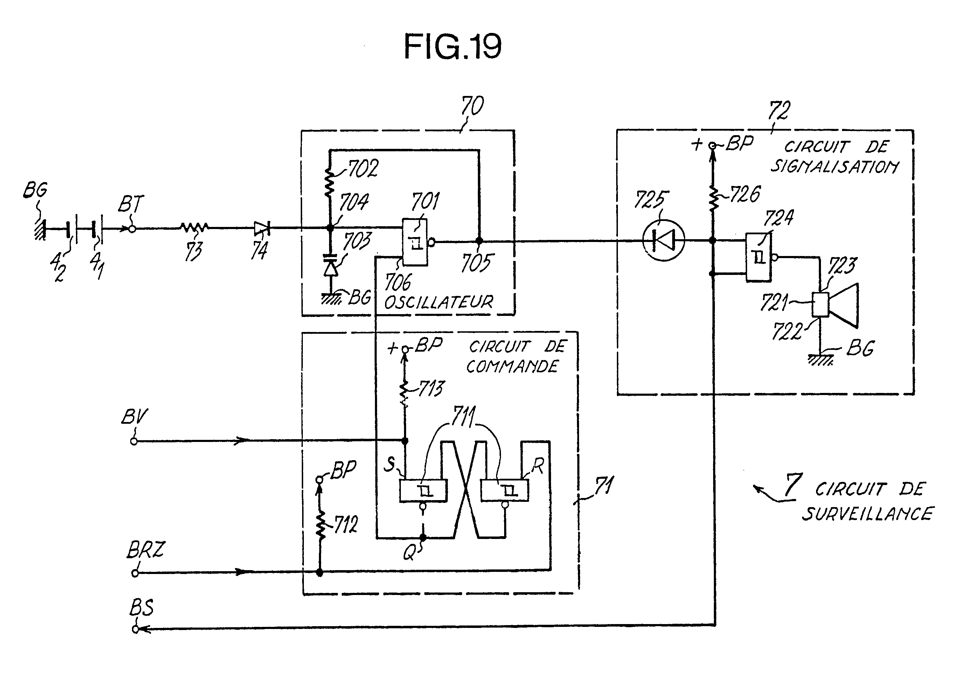

la Fig. 19 est un bloc-diagramme du circuit de surveillance;

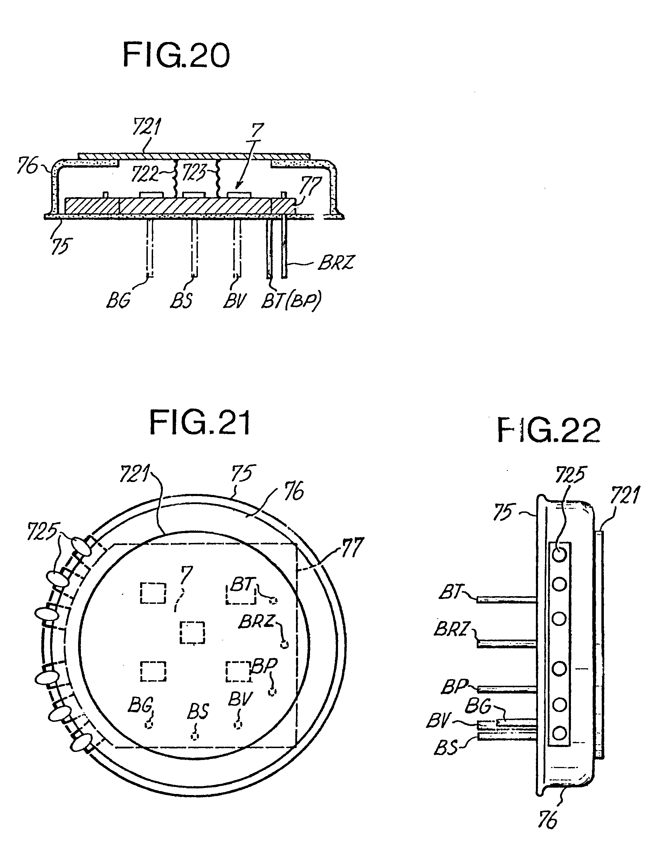

les Figs. 20, 21 et 22 sont des vues schématiques en coupe transversale, de dessus, et longitudinale d'un boîtier contenant le circuit de surveillance, respectivement;

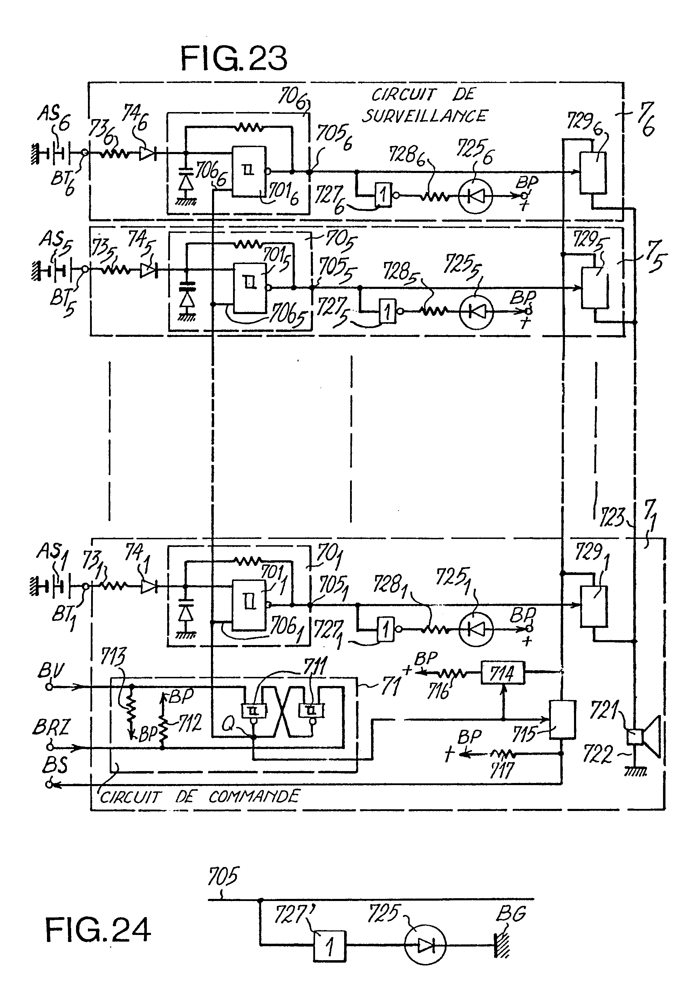

la Fig. 23 est un bloc-diagramme du circuit de surveillance commun à six supports selon l'invention;

la Fig. 24 montre une variante de la connexion d'un dispositif de visualisation dans le circuit de surveillance de la Fig. 23; et

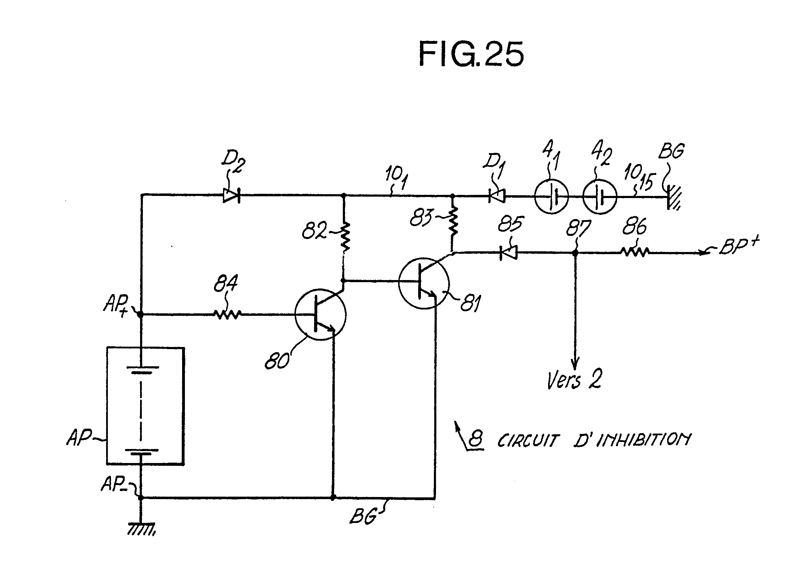

la Fig. 25 est un bloc-diagramme du circuit d'inhibition de fonction.

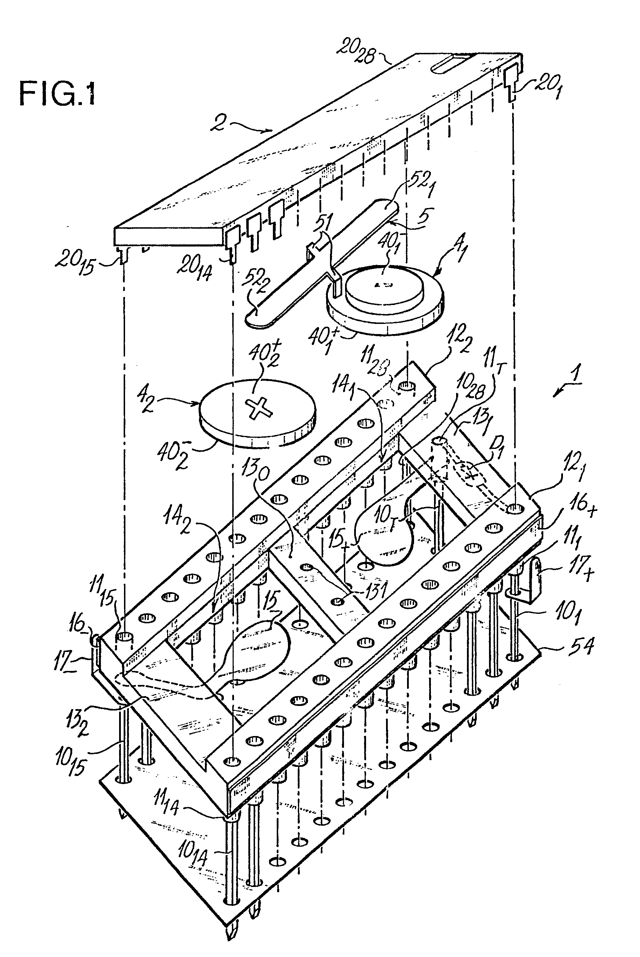

Selon un premier mode de réalisation montré à la Fig. 1, un support 1 selon l'invention est destiné à supporter un boîtier de circuit intégré standard 2 ayant 28 broches métalliques $20_1$ à $20_{28}$. Le boîtier 2 est parallélépipédique et plat et est du type DIL («dual-in-line package» en anglais), ou en d'autres termes, les broches sont réparties en deux rangées $20_1$ à $20_{14}$ et $20_{15}$ à $20_{28}$ s'étendant verticalement sous des côtés longitudinaux du boîtier 2. Deux broches voisines dans l'une des deux rangées sont espacées du pas standard p = 2,54 mm de circuits intégrés. Un module de circuit intégré est encapsulé dans le boîtier 2 et est une mémoire en technologie CMOS du type à accès aléatoire RAM par exemple.

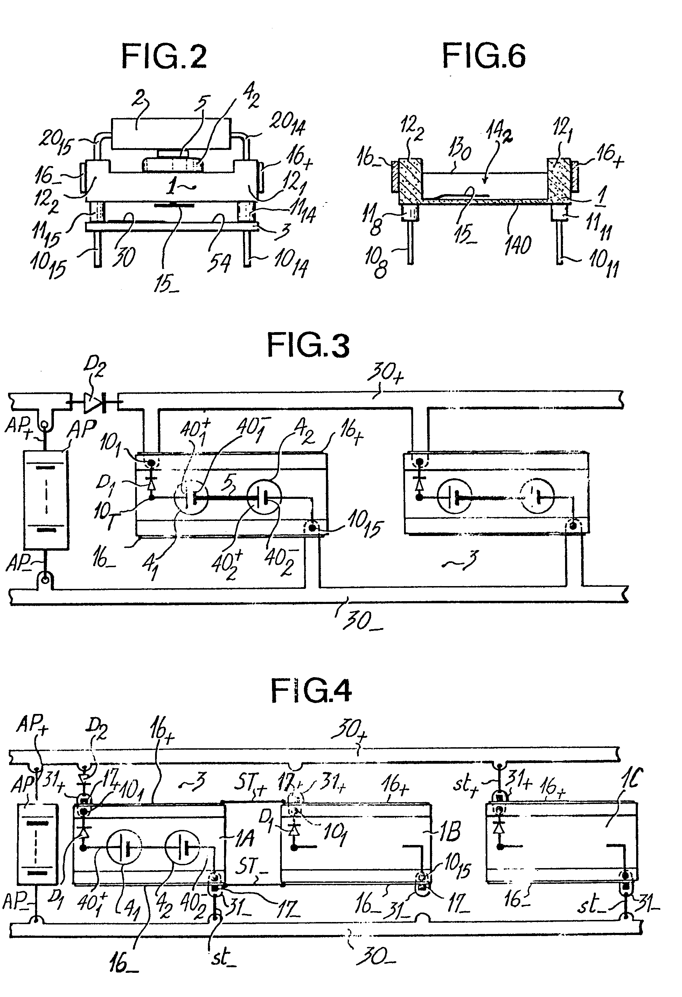

Le support 1 est en une matière plastique moulée et a également une forme parallélépipédique ayant des dimensions sensiblement plus grandes que celles du boîtier 2. Le support 1 comporte également deux rangées longitudinales de broches métalliques verticales $10_1$ à $10_{14}$ et $10_{15}$ à $10_{28}$ saillantes sous le support. Chaque broche $10_1$ à $10_{28}$ du support est terminée en partie supérieure par un fourreau $11_1$ à $11_{28}$ d'un genre connu, par exemple à lames conductrices flexibles. Le fourreau $11_1$ à $11_{28}$ est solidaire du support 1 dans un trou vertical adéquat du support 1 afin de recevoir par enfichage une broche verticale respective $20_1$ à $20_{28}$ du boîtier 2. Les broches conductrices $10_1$ à $10_{28}$ sont respectivement reliées par wrapping ou soudage à des conducteurs, tels que ceux 30 d'une carte de circuit imprimé 3. Dans ce dernier cas, des bases inférieures de fourreaux $11_1$ à $11_{28}$ butent contre la surface de la carte de circuit imprimé au-dessus de trous métallisés de la carte traversés par les broches $10_1$ à $10_{28}$. Comme montré schématiquement à la Fig. 2, le support 1 est disposé entre le boîtier 2 et la carte 3, et chaque broche $10_1$ à $10_{28}$ relie électriquement une broche respective $20_1$ à $20_{28}$ à au moins un conducteur imprimé sur la carte 3 tel que le conducteur 30.

Le support 1 présente une section transversale en U ayant des branches s'étendant verticalement vers le haut et orientées vers le boîtier 2. Les branches longitudinales du U forment des longerons $12_1$ et $12_2$ dotés de trous verticaux pour contenir respectivement les fourreaux respectifs $11_1$ à $11_{14}$ et $11_{15}$ à $11_{28}$. Une traverse centrale $13_0$ et deux traverses d'extrémité $13_1$ et $13_2$ du support 1 relient les longerons $12_1$ et $12_2$ et forment entre elles deux lumières carrées $14_1$ et $14_2$.

Les lumières $14_1$ et $14_2$ constituent des loge-

ments pour recevoir respectivement deux piles miniatures du genre piles boutons $4_1$ et $4_2$ formant une source d'alimentation de secours. Les piles peuvent être des piles connues à l'argent, au mercure ou, de préférence, au lithium, couramment utilisées en microélectronique. Des surfaces métalliques discoïdes sur les faces de chaque pile $4_1$, $4_2$ constituent une borne positive $40_1^+$, $40_2^+$ et une borne négative $40_1^-$, $40_2^-$ de la pile. En général, comme illustré à la Fig. 1, la surface métallique de la borne positive de la pile recouvre totalement l'une des faces de la pile et le contour cylindrique externe de la pile, tandis que la surface métallique de la borne négative de la pile est une surface saillante concentrique à l'autre face de la pile et ayant un diamètre plus petit que celui de ladite autre face.

Chaque pile peut être remplacée par une batterie miniature d'accumulateurs, par exemple au plomb ou au cadmium/nickel. La batterie d'accumulateurs est alors rechargeable par une alimentation principale AP du circuit imprimé.

D'une manière générale, chaque source élémentaire d'alimentation de secours telle qu'une pile $4_1$, $4_2$ est un petit boîtier étanche et délivre une tension au plus égale à 1,5 volt. Ainsi, deux piles mises en série produisent une tension de l'ordre de 2 à 3 volts qui peut relayer une source d'alimentation principale défaillante d'un circuit intégré.

Les piles $4_1$ et $4_2$ sont montées d'une manière amovible dans les lumières $14_1$ et $14_2$ du support 1 et sont connectées en série comme montré à la Fig. 3.

La borne positive $40_1^+$ de la première pile $4_1$ est reliée à une anode d'une diode de blocage $D_1$ à travers une lame de liaison sensiblement horizontale $15_+$ et un fourreau $11_T$ d'une broche de test $10_T$ du support 1. La lame $15_+$ est une forme de poêle et est en matériau conducteur semi-rigide ou flexible. Une partie circulaire de la lame $15_+$ est sous-jacente au milieu de la lumière $14_1$ et supporte la borne discoïde $40_1^+$. Une queue de la lame $15_+$ s'étend sensiblement longitudinalement et est soudée au voisinage d'une base inférieure du fourreau $11_T$ de la broche de test $10_T$ située sous la traverse $13_1$ entre les broches $10_1$ et $10_{28}$. La diode $D_1$ est de préférence complètement enrobée dans la traverse $13_1$ bien que, selon une autre variante, la diode $D_1$ peut être disposée sur la traverse $13_1$. L'anode de la diode $D_1$ est soudée au fourreau $11_T$. Une cathode de la diode $D_1$ est soudée au fourreau $11_1$ de la broche $10_1$. Le fourreau $11_1$ reçoit la broche $20_1$ du boîtier qui forme une borne d'alimentation positive du circuit intégré. Comme montré à la Fig. 3, la broche $10_1$ est reliée par soudure à un conducteur $30_+$ imprimé sur la carte 3 et relié à une borne positive $AP_+$ de l'alimentation principale AP du circuit imprimé à travers une diode de blocage $D_2$ sur la carte 3. La diode $D_2$ a une anode reliée à la borne positive de l'alimentation principale AP et une cathode reliée à la borne négative $40_1^+$ de la pile $4_1$ à travers le conducteur imprimé $30_+$ et la diode $D_1$.

Une borne d'alimentation négative du circuit intégré dans le boîtier 2 est constituée par la broche $20_{15}$ diagonalement opposée à la broche d'alimentation positive $20_1$. La broche $20_{15}$ est reliée à la borne négative $40_2^-$ de la seconde pile $4_2$ également à travers une lame de liaison en matériau conducteur semi-rigide ou flexible en forme de poêle $15_-$. Une partie circulaire de la lame $15_-$ est sous-jacente au milieu de la seconde lumière $14_2$ et reçoit la borne discoïde négative $40_2^-$ de la pile $4_2$. Une queue de la lame $15_-$ est coudée et est soudée à la base inférieure du fourreau $11_{15}$ de la broche $10_{15}$ sous le lengeron $12_2$. Comme montré à la Fig. 3, la broche $10_{15}$ est reliée par soudure à un conducteur $30_-$ imprimé sur la carte 3, relié directement à une borne négative $AP_-$ ou référée à la terre de l'alimentation principale AP. L'alimentation principale AP et l'alimentation de secours $4_1$ - $4_2$ sont ainsi en parallèle entre les bornes $20_1$ et $20_{15}$ par l'intermédiaire des diodes de blocage $D_1$ et $D_2$, ce qui permet de maintenir une tension d'alimentation pratiquement constante en cas de défaillance de l'alimentation principale.

Comme montré à la Fig. 1, la borne négative $40_1^-$ de la première pile $4_1$ est reliée à la borne positive $40_2^+$ de la seconde pile $4_2$ par l'intermédiaire d'une barrette de liaison électrique en matériau conducteur semi-rigide ou flexible 5. La barrette 5 est rectangulaire et est disposée longitudinalement de part et d'autre de la traverse centrale $13_0$. Deux pattes transversales s'étendant vers le bas 51 et au milieu de la barrette 5 sont enfichées dans deux trous verticaux 131 de la traverse centrale $13_0$ et, simultanément, des extrémités $52_1$ et $52_2$ de la barrette sont plaquées contre les bornes de pile $40_1^-$ et $40_2^+$. Dans le support 1, chaque pile $4_1$, $4_2$ est ainsi maintenue entre la lame respective $15_+$, $15_-$ et l'extrémité respective $52_1$, $52_2$ de la barrette 5. Les lames $15_+$ et $15_-$ peuvent être sensiblement cambrées vers le haut, et des demi-portions de la barrette 5 de part et d'autres des pattes 51 peuvent être sensiblement cambrées vers le bas afin d'enserrer plus fortement les piles. Comme montré à la Fig. 2, les piles $4_1$ et $4_2$ sont sensiblement plus épaisses que le support 1, ce qui permet à une grande face inférieure du boîtier 2 d'être plaquée contre la barrette 5 afin que le boîtier 2 et le support 1 avec les piles forment un ensemble unitaire. Le cas échéant, l'assemblage du support 1 et du boîtier 2 peut être consolidé en soudant les broches $20_1$ à $20_{28}$ aux fourreaux $11_1$ à $11_{28}$.

Une mesure de capacité de la source d'alimentation de secours $4_1$ - $4_2$ peut être effectuée entre la broche de test $10_T$ et la broche $10_{15}$.

Un remplacement des piles est effectué simplement en retirant le boîtier 2 du support 1, c'est-à-dire en retirant les broches $20_1$ à $20_{28}$ des fourreaux $11_1$ à $11_{28}$, puis en elevant la barrette 5 dont les pattes 51 sont dégagées des trous 131. Le retrait du boîtier 2 est effectué au moyen d'une pince extractrice multibroche connue.

Selon une autre variante, la barrette de liaison 5 traverse la traverse centrale $13_0$ et est fixée à celle-ci et a des extrémités $52_1$ et $52_2$ recevant les bornes $40_1^+$ et $40_2^-$; les lames de liaison $15_+$ et $15_-$ sont remplacées par deux lames amovibles du support, analogues à une barrette de liaison montrée à la Fig. 18, enfichables dans des paires de trous métallisés de traverses $13_1$ et $13_2$ et recouvrant les bornes $40_1^-$ et $40_2^-$, sous le boîtier 2 et au-dessus des lumières $14_1$ et $14_2$; les deux paires de trous métallisés sont reliés

aux broches $10_1$ et $10_{15}$ à travers des conducteurs noyés dans le support 1. Les deux lames enfichables peuvent être collées sous le boîtier 2.

Dans la Fig. 1 est également représentée une feuille rectangulaire en matériau isolant. La feuille 54 est disposée horizontalement entre le support 1 et la carte imprimée 3 et est traversée par les broches $10_1$ et $10_{28}$ du support. Après soudage des broches $10_1$ à $10_{28}$ à la carte 3 et assemblage du boîtier et du support, comme montré à la Fig. 2, les lames $15_+$ et $15_-$ peuvent être sensiblement repoussées vers la carte 3. La feuille 54 isole alors la lame $15_+$ en contact avec la borne positive $40_1^+$ de la pile $4_1$ et la lame $15_-$ en contact avec la borne négative $40_2^-$ de la pile $4_2$ par rapport à des conducteurs imprimés de la carte 3 se trouvant sous le support 1.

Le soupport 1 possède également deux pistes métallisées de continuité d'alimentation $16_+$ et $16_-$ qui sont fixées sur des chants longitudinaux verticaux externes des longerons $12_1$ et $12_2$ respectivement, et deux cosses métalliques en équerre $17_+$ et $17_-$ ayant des côtés horizontaux s'étendant vers l'extérieur qui sont traversés par les broches d'alimentation verticales $10_1$ et $10_{15}$ et soudés à celles-ci respectivement. Les pistes $16_+$ et $16_-$ et le cosses $17_+$, $17_-$ sont prévues pour secourir plusieurs supports de circuit intégré ne contenant pas de source d'alimentation de secours, par une source d'alimentation de secours contenue dans un autre support.

Selon l'exemple illustré à la Fig. 4, trois supports de circuit intégré 1A, 1B et 1C analogues au support 1 selon l'invention sont implantés entre des conducteurs parallèles $30_+$ et $30_-$ d'une carte imprimée 3. Les conducteurs $30_+$ et $30_-$ sont reliés directement à la borne positive $AP_+$ et à la borne negative $AP_-$ de la source d'alimentation principale AP alimentant normalement les circuits intégrés sur le support. Relativement à chaque support 1A, 1B et 1C, la broche d'alimentation positive $10_1$ du support est soudée à une première extrémité d'un petit conducteur imprimé $31_+$ ayant une seconde extrémité en vis-à-vis du conducteur $30_+$, et la broche d'alimentation négative $10_{15}$ du support est soudée à une extrémité d'un second petit conducteur imprimé $31_-$ ayant une seconde extrémité en vis-à-vis du conducteur $30_-$.

On suppose que seul le premier support 1A contient une source d'alimentation de secours à deux piles $4_1$ et $4_2$. L'alimentation principale AP alimente normalement le circuit intégré sur le support 1A à travers une diode de blocage $D_2$ interconnectée au conducteur $30_+$ et à la seconde extrémité du conducteur respectif $31_+$, et à travers un strap $st_-$ reliant le conducteur $30_-$ à la seconde extrémité du conducteur $31_-$.

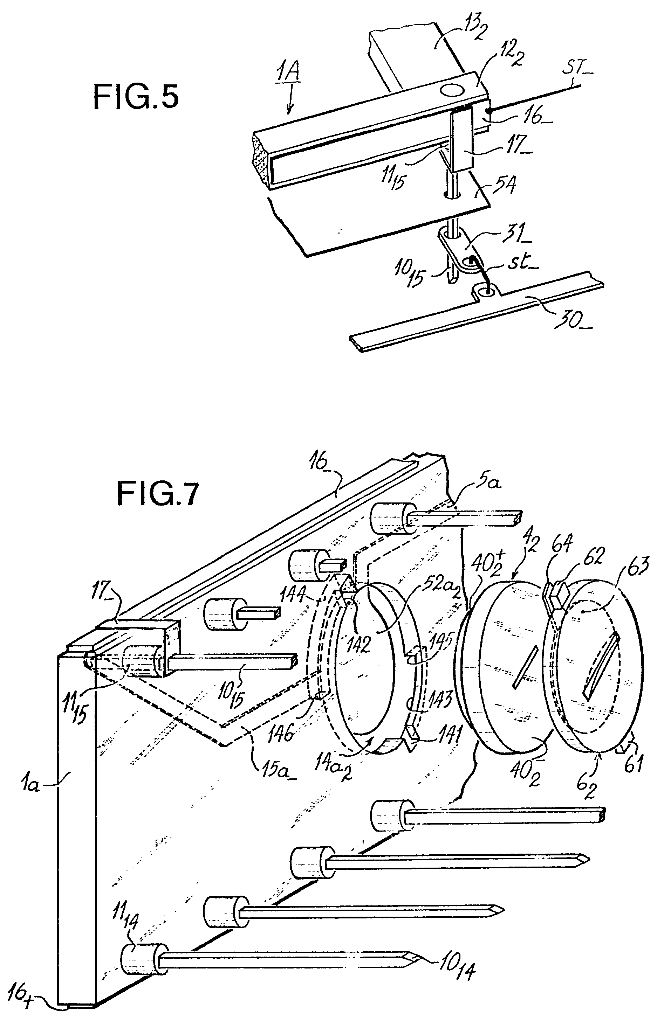

Les connexions suivantes doivent être réalisées pour qu'un circuit intégré supporté par un support sans source d'alimentation de secours, tel que le support 1B, soit secouru par la source de secours $4_1$ - $4_2$ du support 1A et soit alimenté normalement par l'alimentation principale AP. Pour chacun des supports 1A et 1B, des côtés s'étendant vers le haut des cosses en équerre $17_+$ et $17_-$ sont respectivement soudés aux pistes conductrices $16_+$ et $16_-$. Des extrémités d'un premier strap $ST_+$ sont soudées à des extrémités voisines des pistes $16_+$ des supports 1A et 1B respectivement, et les extrémités d'un second strap $ST_-$ sont soudées à des extrémités voisines des pistes $16_-$ des supports 1A et 1B respectivement. Ainsi, la borne d'alimentation positive du circuit intégré supporté par le support 1B est reliée à la borne positive $AP_+$ de l'alimentation principale AP à travers les éléments $11_1$, $10_1$, $17_+$ et $16_+$ du support 1B, le strap $ST_+$, les éléments $16_+$, $17_+$ et $10_1$ du support 1A, le petit conducteur $31_+$ et la diode $D_2$ relatifs au support 1A et le conducteur $30_+$, et est reliée à la borne positive $40_1^+$ de la source d'alimentation de secours $4_1$ - $4_2$ dans le support 1A à travers les éléments $11_1$, $10_1$, $17_+$ et $16_+$ du support 1B, le strap $ST_+$ et les éléments $16_+$, $17_+$, $10_1$, $11_1$, $D_1$, $11_T$ et $15_+$ du support 1A. La borne d'alimentation négative du circuit intégré supporté par le support 1B est reliée à la borne négative $AP_-$ de l'alimentation principale AP à travers les éléments $11_{15}$, $10_{15}$, $17_-$ et $16_-$ du support 1B, le strap $ST_-$, les éléments $16_-$, $17_-$ et $10_{15}$ du support 1A, le petit conducteur $31_-$ et le strap $st_-$ relatifs au support 1A, et le conducteur $30_-$ et est reliée à la borne négative $40_2^-$ de la source d'alimentation de secours $4_1$ - $4_2$ dans le support 1A à travers les éléments $11_{15}$, $10_{15}$, $17_-$ et $16_-$ du support 1B, le strap $ST_-$ et les éléments $16_-$, $17_-$, $10_{15}$ et $15_-$ du support 1A. Les connexions au niveau de la broche $10_{15}$ du support 1A sont illustrées en détail à la Fig. 5.

Si un circuit intégré est supporté par un support ne contenant pas de source d'alimentation de secours, tel que le support 1C, et est directement alimenté par l'alimentation principale AP par pose d'un petit strap $st_+$ entre le conducteur $30_+$ et le petit conducteur $31_+$ relatif au support 1C et par pose d'un second petit strap $st_-$ entre le conducteur $30_-$ et le petit conducteur $31_-$ relatif au support 1C, l'une des deux solutions suivantes est possible pour secourir le circuit intégré. Une première solution consiste à remplacer le strap $st_+$ relatif au support 1C par une diode de blocage telle que $D_2$ et à introduire dans le support 1C deux piles miniatures de secours. Une seconde solution consiste à ôter les straps $st_+$ et $st_-$ relatifs au support 1C et à poser deux straps, tel que des straps $ST_+$ et $ST_-$, entre les pistes $16_+$ et $16_-$ du support 1C et entre les pistes $16_+$ et $16_-$ d'un support voisin secouru, tel que le support 1B, respectivement.

Les pistes conductrices $16_+$ et $16_-$ et les cosses conductrices $17_+$ et $17_-$ du support selon l'invention servent également à tester manuellement chacune des piles contenues dans le support.

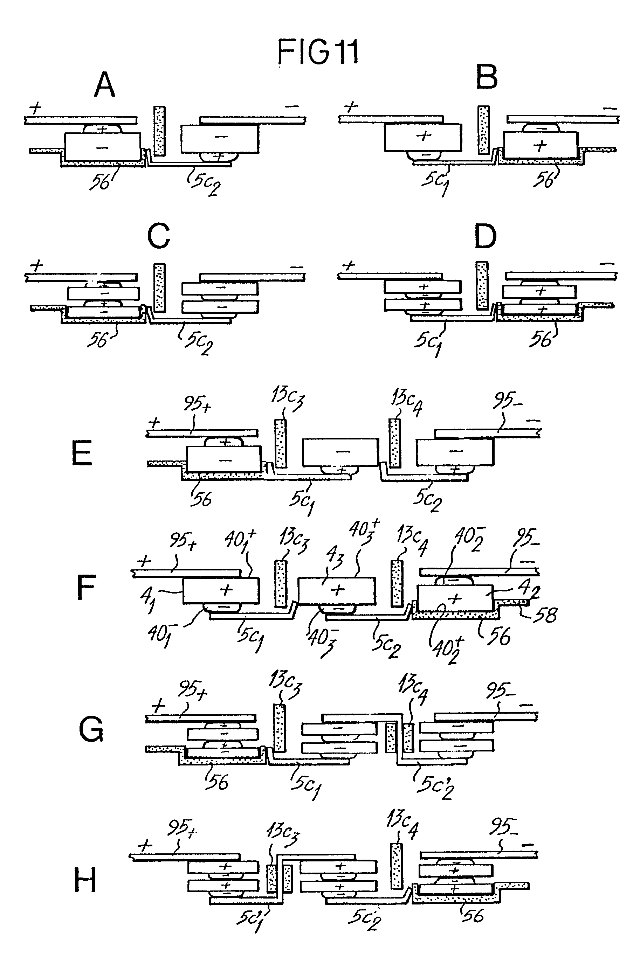

D'autres variantes de structure de support de boîtier de circuit intégré peuvent être envisagées pour contenir un nombre adéquat de piles ou de batteries d'accumulateurs miniatures en fonction de la tension d'alimentation du circuit intégré. Un support selon l'invention peut contenir quatre piles boutons en remplaçant chaque pile $4_1$, $4_2$ par deux piles plus minces superposées et connectées en série, comme on le verra en référence aux Figs. 11C et 11D. Un support peut également offrir trois logements pour recevoir chacun une pile bouton épaisse ou une paire de piles boutons plus minces, comme on le verra en

référence aux Figs. 11E à 11H. Un support peut également offrir deux logements contenant chacun trois piles boutons très minces empilées et connectées en série. L'augmentation du nombre de piles se fait en choisissant des piles d'épaisseurs différentes. Dans tous les cas, les dimensions du support sont adaptées aux dimensions du boîtier du circuit intégré, et notamment au nombre de broches du boîtier qui peut être par exemple égal à 14, 16, 20, 28 ou 40, ou bien à 64 pour un microprocesseur.

Les faces inférieures des lumières $14_1$ et $14_2$ peuvent être fermées par un fond venu de moulage 140 pour former deux cavités, comme montré schématiquement à la Fig. 6; le fond 140 remplace la feuille isolante 54 montrée aux Figs. 1 et 2. De préférence, la section horizontale des logements tels que lumières $14_1$, $14_2$ ou cavités est semblable à celle des piles ou des accumulateurs afin d'éviter tout déplacement possible des piles ou des accumulateurs dans le support. La barrette 5 couplant les piles $4_1$ et $4_2$ et montrée à la Fig. 1 peut être remplacée par un film de cuivre adhésif qui est collé sous le boîtier 2 et dont les extrémités viennent au contact des bornes $40_1^-$ et $40_2^+$ lors de l'enfichage des broches $20_1$ à $20_{28}$ dans les fourreaux $11_1$ à $11_{28}$.

A titre d'exemple non limitatif, on décrit maintenant en détail deux variantes de support à deux piles pour enfermer hermétiquement les piles et une variante de support à au moins trois piles pour assembler aisément et solidement sans soudage le support et un boîtier de circuit intégré.

Selon la variante montrée à la Fig. 7, deux piles boutons, telles que la pile $4_2$, sont logées respectivement dans deux cavités circulaires moulées, telles que $14a_2$, s'étendant parallèlement aux grandes faces d'un support 1a ayant 28 broches. Un conducteur discoïde $52a_2$ est imprimé sur un fond de la cavité $14a_2$ ou est sous la forme d'une plaque métallique circulaire flexible vers le bas sur le fond de la cavité $14a_2$. Le conducteur $52a_2$ est relié à un conducteur analogue logé au fond d'une autre cavité moulée (non représentée) à travers un conducteur 5a noyé dans le support 1a. La cavité $14a_2$ a un diamètre sensiblement égal à celui de la pile bouton $4_2$ et une hauteur sensiblement égale à la somme des épaisseurs de la pile $4_2$ et d'un couvercle discoïde $6_2$ ayant tous deux un même diamètre externe. La fermeture de la cavité $14a_2$ contenant la pile par le couvercle $6_2$ est verrouillée par un assemblage à baïonnette. Deux ergots de verrouillage 61 et 62 sont diamétralement opposés et s'étendent à partir de la périphérie du couvercle face à la cavité $14a_2$. Une face interne du couvercle $6_2$ orientée vers la borne $40_2^-$ de la pile $4_2$ est munie d'un disque conducteur imprimé ou d'une plaque métallique circulaire flexible 63 fixé au couvercle. Le conducteur 63 est prolongé par une patte 64 disposée sous-jacente à l'ergot 62. A la périphérie de la cavité $14a_2$ sont prévues des fentes 141 et 142 diamétralement opposées et deux rainures borgnes circulaires d'un quart de tour 143 et 144 également diamétralement opposées. Une extrémité de chaque rainure 143, 144 est formée par une fente respective 141, 142 propre à recevoir l'ergot 61, 62, et une autre extrémité de chaque rainure forme une butée 145, 146 pour l'ergot respectif 61, 62 après rotation d'un quart de tour du couvercle $6_2$. Devant la butée 146 émerge une extrémité d'un conducteur $15a_-$ dans le fond de la rainure 144. Le conducteur $15a_-$ est complètement enrobé dans le support 1a et a une autre extrémité reliée au fourreau $11_{15}$ de la broche d'alimentation négative $10_{15}$. Ainsi, après fermeture de la cavité $14a_2$ par le couvercle $6_2$, la patte 64 du couvercle $6_2$ est en contact avec le conducteur $15a_-$, ce qui relie la broche d'alimentation $10_{15}$ à la borne négative $40_2^-$ de la pile $4_2$. Du côté de la pile $4_1$, non représentée dans la Fig. 7, un conducteur analogue au conducteur $15a_-$ relie la borne $40_1^+$ de la pile $4_1$ au fourreau $11_T$ de la broche de test $10_T$ à travers des patte et disque conducteurs fixés sous un couvercle respectif analogue au couvercle $6_2$.

Les disques conducteurs $52a_2$ et 63 sont de préférence des plaques conductrices souples ayant des flexions propres opposées afin de faciliter le retrait du couvercle, puis l'extraction de la pile.

Une face du support 1a dans laquelle sont pratiquées les cavités, telles que la cavité $14a_2$, recevant les piles $4_1$ et $4_2$ peut être la face supérieure du support 1a en regard du boîtier du circuit intégré 2 ou la face inférieure du support 1a en regard de la carte de circuit imprimé 3, auquel cas les broches $10_1$ à $10_{28}$ du support sont suffisamment longues pour accéder aisément aux couvercles, tels que le couvercle $6_2$ montré à la Fig. 7.

Une autre structure de support sensiblement modifiée par rapport à celle décrite précédemment en référence à la Fig. 7 est maintenant décrite. Cette autre structure ne comporte qu'un couvercle, tel que le couvercle $6_2$, fermant la cavité correspondante $14a_2$ qui communique avec la première cavité propre à recevoir la pile $4_1$ à travers un couloir ayant une largeur au moins égale au diamètre des piles $4_1$ et $4_2$. La première cavité possède des parois parallèles formées par les grandes faces pleines du support 1a. Les deux cavités forment ainsi une cavité oblongue continue, ne débouchant vers l'extérieur qu'au niveau de la cavité ouverte $14a_2$. Dans ce cas, la pile $4_1$ est d'abord introduite dans la seconde cavité $14a_2$ puis poussée à fond dans l'autre cavité à travers le couloir. La seconde pile $4_2$ est introduite dans la cavité $14a_2$ et est recouverte par le couvercle $6_2$. Un petit trou longitudinal entre la première cavité et un chant transversal du support 1a latéral à celle-ci permet d'y introduire une tige pour pousser la pile $4_1$ vers la cavité $14a_2$ en vue d'extraire la pile $4_1$ du support 1a.

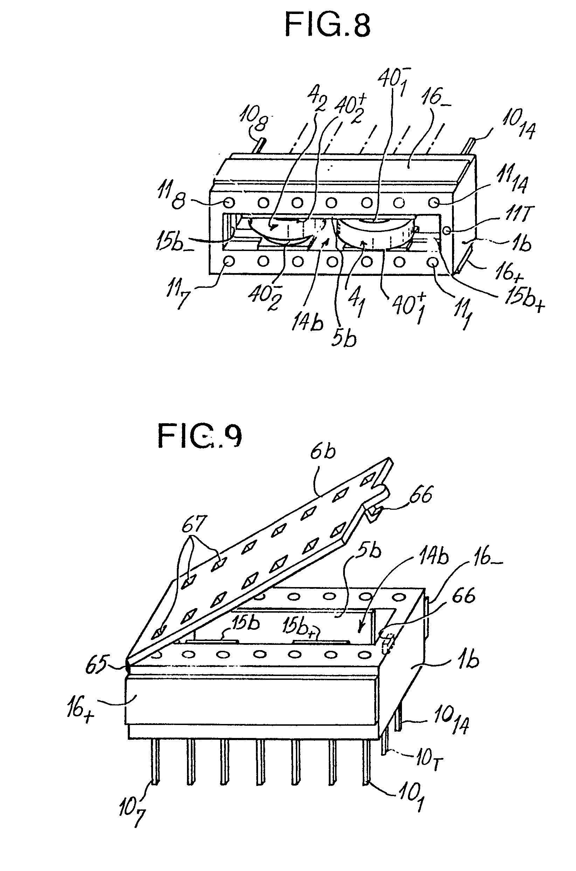

Selon une autre variante montrée schématiquement aux Figs. 8 et 9, les piles boutons $4_1$ et $4_2$ sont disposées verticalement et juxtaposées dans une unique cavité parallélépipédique 14b d'un support 1b. Les axes des piles sont parallèles aux grandes faces du boîtier 2 et à la carte du circuit imprimé 3. Le support 1b comporte 14 broches $10_1$ à $10_{14}$ avec fourreaux $11_1$ à $11_{14}$ pour recevoir 14 broches $20_1$ à $20_{14}$ d'un boîtier de circuit intégré (non représenté). Les grandes parois longitudinales verticales du support 1b supportent respectivement deux rangées de broches $10_1$ à $10_7$ et $10_8$ à $10_{14}$. Les fourreaux des broches diagonalement opposées $10_1$ et $10_8$ reçoivent respectivement les broches d'alimentation positive $20_1$ et négative $20_8$ du boîtier de circuit intégré.

La largeur de la cavité 14b est sensiblement égale à l'épaisseur des piles $4_1$ et $4_2$. Les piles sont également disposées tête-bêche. La borne négative $40_1^-$ de la pile $4_1$ et la borne positive $40_2^+$ de la pile $4_1$ sont plaquées contre des extrémités d'un conducteur 5b imprimé ou rapporté sur une grande face longitudinale verticale de la cavité 14b, tandis que la borne positive $40_1^+$ de la pile $4_1$ et la borne négative $40_2^-$ de la pile $4_2$ sont plaquées contre deux conducteurs flexibles respectifs $15b_+$ et $15b_-$ rapportés sur une autre grande face longitudinale verticale de la cavité 14b; le conducteur $15b_+$ est relié au fourrreau $11_T$ de la broche de test $10_T$ et le conducteur $15b_-$ est relié à la broche d'alimentation négative $10_8$.

Le support 1b a une épaisseur non standard sensiblement supérieure au diamètre des piles boutons. L'intérieur de la cavité 14b est accessible par le dessus du support, du côté du boîtier de circuit intégré.

Un couvercle 6b est articulé sur le support 1b par une charnière moulée 65 afin de fermer la cavité 14b et y maintenir les piles en l'absence de boîtier de circuit intégré. Comme montré à la Fig. 9, le couvercle 6b est verrouillé sur le dessus du support par un assemblage à cliquet et encoche 66. Des trous 67 sont pratiqués au voisinage des bords longitudinaux du couvercle 6b pour le libre passage des broches respectives $20_1$ à $20_{14}$ du boîtier vers les fourreaux respectifs $11_1$ à $11_{14}$ du support 1b. En pratique, un support tel que le support 1b illustré aux Figs. 8 et 9 est destiné généralement à supporter un boîtier de circuit intégré ayant 14, 16, 18, 20 ou 22 broches.

La Fig. 10 montre un support 1c pour supporter un boîtier de circuit intégré 2c ayant deux rangées de 20 broches $20c_1$ à $20c_{20}$ et $20c_{21}$ à $20c_{40}$. Le support 1c est en une matière plastique moulée et a une forme parallélépipédique analogue à celle du support 1 montré à la Fig. 1. Cependant, le support 1c offre trois lumières carrées 14c, $14c_2$ et $14c_3$ alignées longitudinalement entre deux longerons $12c_1$ et $12c_2$ et deux traverses d'extrémité $13c_1$ et $13c_2$, la lumière $14c_3$ étant une lumière centrale au support, et séparée des deux lumières $14c_1$ et $14c_2$ par deux traverses intermédiaires $13c_3$ et $13c_4$. Chaque lumière $14c_1$, $14c_2$, $14c_3$ est propre à recevoir une pile bouton $4_1$, $4_2$, $4_3$ ayant un diamètre sensiblement plus petit qu'un côté de lumière. Seule la pile $4_2$ est représentée dans la Fig. 10. Le support 1c comporte deux rangées longitudinales de broches métalliques verticales $10c_1$ à $10c_{20}$ et $10c_{21}$ à $10c_{40}$ saillant sous les longerons $12c_1$ et $12c_2$ et ayant des fourreaux verticaux $11c_1$ à $11c_{20}$ et $11c_{21}$ à $11c_{40}$ saillant sur les longerons $12c_1$ et $12c_2$. Les fourreaux $11c_1$ à $11c_{40}$ sont propres à recevoir les extrémités des broches $20c_1$ à $20c_{40}$ du boîtier de circuit intégré 2c. Les broches $10c_1$ et $10c_{21}$ diagonalement opposées dans le support reçoivent les broches $20c_1$ et $20c_{21}$ du boîtier formant les bornes d'alimentation positive et négative du circuit intégré. D'une manière analogue à la réalisation de la Fig. 1, des cosses métalliques en équerre $17c_+$ et $17c_-$ sont soudées aux broches d'alimentation $10c_1$ et $10c_{21}$ et peuvent être soudées à des pistes métalliques de continuité d'alimentation $16c_+$ et $16c_-$, fixées sur des chants longitudinaux verticaux externes des longerons $12c_1$ et $12c_2$. Une feuille rectangulaire en matériau isolant 54c est également disposée sous le support 1c et traversée par les broches $10c_1$ à $10c_{40}$.

On supposera dans la suite que les piles $4_1$, $4_2$ et $4_3$ sont reliées en série comme montré à la Fig. 11F: les piles $4_1$ et $4_3$ ont des bornes positives $40_1^+$ et $40_3^+$ orientées vers le haut, et la pile $4_2$ a une borne positive $40_2^+$ orientée vers le bas. Deux barrettes métalliques flexibles de liaison en équerre $5c_1$ et $5c_2$ sont prévues pour relier les piles $4_1$ et $4_2$ et les piles $4_3$ et $4_2$. Les barrettes $5c_1$ et $5_2$ ont des ailes plates horizontales traversant les milieux des traverses intermédiaires $13c_3$ et $13c_4$ et s'étendant au moins jusqu'au milieu des lumières $14c_1$ et $14c_3$ et ont des ailes plates verticales d'étendant vers le haut à proximité des traverses $13c_3$ et $13c_4$ dans les lumières $14c_3$ et $14c_2$, respectivement. Ainsi, lorsque les piles $4_1$, $4_2$ et $4_3$ sont introduites dans les lumières respectives $14c_1$, $14c_2$ et $14c_3$, comme montré à la Fig. 11F, les ailes horizontales des barrettes $5c_1$ et $5c_2$, de préférence sensiblement cambrées vers le haut, sont au contact de petites bornes négatives $40_1^-$ et $40_3^-$ des piles $4_1$ et $4_3$ et supportent les piles $4_1$ et $4_3$, tandis que les ailes verticales des barrettes $5c_1$ et $5c_2$, de préférence sensiblement cambrées vers la traverse $13c_2$, sont appliquées contre les contours cylindriques métalliques des bornes positives $40_3^+$ et $40_2^+$ des piles $4_3$ et $4_2$, respectivement.

La pile $4_2$ est supportée par une coiffe cylindrique 56 en matière isolante moulée. La coiffe 56 joue le rôle d'interrupteur entre la source d'alimentation de secours $4_1$ - $4_3$ - $4_2$ et les broches d'alimentation $10c_1$ et $10c_{21}$, afin de mettre en service ou non l'alimentation de secours. La coiffe 56 comporte un fond circulaire contre lequel est appliquée la grande borne positive $40_2^+$ de la pile $4_2$. Une paroi cylindrique s'étendant vers le haut de la coiffe 56 est échancrée pour former au moins deux segments cylindriques diamétralement opposés et flexibles vers le centre de la coiffe ou, de préférence, comme illustré à la Fig. 10, quatre segments cylindriques 57 diamétralement opposés deux à deux, afin d'enserrer la périphérie circulaire métallique de la borne $40_2^+$. Les segments 57 ont une hauteur sensiblement plus petite que l'épaisseur de la pile $4_2$ et la coiffe 56 a un diamètre externe sensiblement égal aux côtés de la lumière carrée $14c_2$. Dans ces conditions, la coiffe 56 avec la pile $4_2$ peut tourner à frottement doux entre les parois internes de la lumière $14c_2$, et la petite aile verticale de la barrette de liaison $5c_2$ est appliquée par sa flexion propre tantôt contre l'un des segments isolants 57 pour déconnecter la borne $40_2^+$ de la pile $4_2$ par rapport à la borne $40_3^-$ de la pile $4_3$, et donc pour mettre hors de service l'alimentation de secours, tantôt contre la périphérie circulaire métallique de la borne $40_2^+$ pour mettre en service l'alimentation de secours, et donc connecter en série les piles $4_1$, $4_3$ et $4_2$ entre les broches $10c_1$ et $10c_{21}$. Ces déconnexion et connexion sont en fait obtenues par une rotation d'environ un quart de tour de la coiffe 56, au moyen d'un levier 58 s'étendant radialement vers l'extérieur à partir de l'un des segments 57. Une extrémité libre flexible du levier émerge sensiblement du support 1c à partir de la traverse d'extrémité $13c_2$ et peut être engagée soit dans une rainure oblique 59S à proximité de la broche $10c_{21}$ et sur la traverse $13c_2$, soit dans une rainure sensiblement transversale 59H sur la traverse $13c_2$ entre le milieu de celle-ci et la rainure 59S. Les rainures 59S et 59H constituent des crans d'arrêt pour la rotation de la coiffe 56 et correspondent respectivement à des positions du segment 57 diamétralement opposé au levier 58, auxquelles le segment 57 est par côté de la barrette $5c_2$ et est en contact mécanique avec la barrette $5c_2$.

Comme montré à la Fig. 10, le support $1c$ est associé à un couvercle amovible 9 permettant des connexion et déconnexion aisées sans soudure des broches $20c_1$ à $20c_{40}$ du boîtier de circuit intégré $2c$ par rapport aux fourreaux $11c_1$ à $11c_{40}$ du support $1c$ d'une part, et un maintien des piles $4_1$, $4_2$ et $4_3$ dans le support $1c$ notamment en l'absence de boîtier $2c$.

Le couvercle 9 est un cadre rectangulaire en matière plastique moulée ayant des largeur et longueur sensiblement inférieures à celles du support $1c$ et formé par deux longerons $92_1$ et $92_2$ et deux traverses d'extrémité $93_1$ et $93_2$. Deux traverses intermédiaires $93_3$ et $93_4$ partagent le couvercle 9 en trois lumières carrées $94_1$, $94_3$ et $94_2$ superposables aux lumières $14c_1$, $14c_3$ et $14c_2$. Les traverses $93_1$ à $93_4$ présentent une section convexe vers le haut, par exemple trapézoïdale comme montré à la Fig. 10, de sorte que les longerons $92_1$ et $92_2$ soient seulement appliqués contre le support $1c$, c'est-à-dire sur les longerons $12c_1$ et $12c_{21}$ lorsque le couvercle 9 recouvre le support $1c$. Le couvercle 9 est alors encadré par des parois minces longitudinales 121 et 122 à la périphérie du support $1c$, prolongeant vers le haut les longerons $12c_1$ et $12c_2$ et ayant des extrémités formant des encoignures droites aux quatre coins du support. Selon la réalisation illustrée à la Fig. 10, deux pattes flexibles de verrouillage $98_1$ et $98_2$ s'étendent verticalement vers le bas sous le milieu des traverses d'extrémité $93_1$ et $93_2$ et ont des paires de nervures horizontales supérieures $981_1$, $981_2$ et inférieures $982_1$, $982_2$ vers l'extérieur pour coopérer avec des rainures verticales centrales vers l'intérieur $130_1$ et $130_2$ et des orifices rectangulaires $131_1$ et $131_2$ pratiqués dans les traverses $13c_1$ et $13c_2$ respectivement. Les orifices $131_1$ et $132_2$ sont respectivement au milieu des traverses d'extrémité $13c_1$ et $13c_2$, et la distance verticale entre deux nervures inférieure et supérieure de chaque patte $98_1$ et $98_2$ est égale à la demi-épaisseur des traverses $13c_1$ et $13c_2$. Les pattes $98_1$ et $98_2$ coulissent dans les rainures $130_1$ et $130_2$ ouvertes vers les lumières $14c_1$ et $14c_2$, et les paires de nervures $981_1$ - $982_1$ et $981_2$ - $982_2$ enserrent des parties centrales des traverses $13c_1$ et $13c_2$ au-dessus des orifices $131_1$ et $131_2$ lorsque le couvercle 9 est appliqué contre le support $1c$ afin de verrouiller le couvercle au support, comme montré à la Fig. 12.

Les longerons $92_1$ et $92_2$ du couvercle présentent des séries de trous verticaux à section carrée $91_1$ à $91_{20}$ et $91_{21}$ à $91_{40}$ destinés à recevoir par dessous les fourreaux $11c_1$ à $11c_{20}$ et $11c_{21}$ à $11c_{40}$ et par-dessus les broches $20c_1$ à $20c_{20}$ et $20c_{21}$ à $20c_{40}$. Comme montré en détail à la Fig. 12, chaque fourreau, tel que le fourreau $11c_{21}$, est constitué par

deux lames conductrices verticales, ici parallèles aux parois 121 et 122, ayant une hauteur inférieure à celle des trous $91_1$ à $91_{40}$. Lors de l'assemblage du couvercle 9 du support $1c$ en poussant vers le bas le couvercle 9, les nervures inférieures $982_1$ et $982_2$ des pattes $98_1$ et $98_2$ pénètrent d'abord dans les orifices $131_1$ et $131_2$ respectivement, et les lames des fourreaux $11_1$ à $11_{40}$ pénètrent à frottement doux par des extrémités évasées des trous $91_1$ à $91_{40}$. Les côtés longitudinaux externes des longerons $92_1$ et $92_2$ sont verticaux et glissent entre les parois 121 et 122. Puis le boîtier $2c$ recouvre le couvercle 9 afin que les broches $20c_1$ à $20c_{40}$ pénètrent verticalement par des extrémités supérieures évasés des trous $91_1$ à $91_4$ et glissent entre les lames des fourreaux $11c_1$ à $11c_{40}$ respectivement. Une pression vigoureuse est enfin exercée vers le bas sur le boîtier $2c$ afin que les nervures supérieures $981_1$ et $981_2$ pénètrent dans les orifices $131_1$ et $131_2$ et les nervures inférieures $982_1$ et $982_2$ passent dessous les traverses $13c_1$ et $13c_2$. A ce stade, les traverses $93_1$ à $93_4$ du couvercle tendent à s'aplatir et les longerons $92_1$ et $92_2$ sont plus écartés et sont plaqués contre les parois 121 et 122 du support. L'écartement des longerons $92_1$ et $92_2$ pousse sensiblement vers l'extérieur les lames des fourreaux $11c_1$ à $11c_{40}$ qui pincent fermement les extrémités des broches $20c_1$ à $20c_{40}$ et qui établissent de véritables contacts mécaniques et électriques avec celles-ci, sans faire appel à de la soudure. En outre, le couvercle 9 et le boîtier $2c$ sont fermement maintenus en superposition sur le support $1c$. Chaque fois que le boîtier $2c$ est à placer sur le couvercle 9 ou à retirer de celui-ci, le glissement des broches $20c_1$ à $20c_{40}$ dans les fourreaux $11c_1$ à $11c_{40}$ confère un autonettoyage de ces éléments de contact électrique.

Lors d'un retrait du boîtier $2c$, un outil spécial à fourche, ou plus simplement un tournevis, permet de dégager vers le haut les nervures inférieures $982_1$ et $982_2$ du dessous des traverses $13c_1$ et $13c_2$ qui pénètrent ensuite dans les orifices $131_1$ et $131_2$. L'ascension des pattes $98_1$ et $98_2$ est facilitée par la flexion propre des traverses $93_1$ à $93_4$ redevenant plus convexes et des parois 121 et 122 redevenant verticales, le boîtier $2c$ peut être ôté sans que les piles soient nécessairement ôtées, puisque le couvercle 9 est encore verrouillé au support grâce aux nervures inférieures $982_1$ et $982_2$ retenues dans les orifices $131_1$ et $131_2$. Le retrait d'une ou plusieurs piles est obtenu en tirant complètement vers le haut le couvercle 9 afin de dégager les nervures $982_1$ et $982_2$ des orifices $131_1$ et $132_2$.

Selon une autre variante de moyens de verrouillage du couvercle 9 au support $1c$, les pattes $98_1$ et $98_2$ et les ensembles à rainures et fentes $130_1$ - $131_1$ et $130_2$ - $131_2$ sont remplacées par deux pattes cylindriques verticales 99 sous-jacentes aux traverses $93_1$ et $93_2$ et deux trous cylindriques verticaux 132 au milieu des traverses $13c_1$ et $13c_2$, comme montré à la Fig. 13. Chaque patte 99 a une fente verticale diamètrale 990, perpendiculaire aux traverses $93_1$, $93_2$ et un téton conique d'extrémité 991 convergeant vers le bas surmonté d'une collerette 992. Comme montré aux Figs. 14A à 14E, une bague de verrouillage 133 est rapportée à une extrémité supérieure de chaque trou 132 et fixée dans celle-ci. La bague 133 comporte une gorge annulaire 134 à extrémité inférieure conique. Le trou 132 peut être borgne ou offrir une extrémité inférieure 135 ayant un diamètre plus petit que la majeure partie restante du trou afin de former une chambre cylindrique 136 sous la bague 133. Dans la chambre 136 est prévue une rondelle 137 à extrémité supérieure évasée. Les diamètres des alésages dans la bague 133 et la rondelle 137 sont inférieurs au diamètre du téton 991 et sensiblement égaux à la largeur du téton lorsque les branches séparées par la fente 990 sont complètement serrées l'une contre l'autre, comme montré aux Figs. 14A et 14C. Selon d'autres variantes, la section des éléments 99, 133 et 137 et des alésages et trous correspondants peut être carrée ou polygonale par exemple.

Lorsque le couvercle 9 doit être verrouillé au support $1c$ après l'introduction des piles $4_1$ à $4_3$ dans les lumières $14c_1$ à $14c_3$ et avant l'application du boîtier $2c$ sur le couvercle, les collerettes 992 des deux pattes 99 sont engagées dans les gorges 134 des bagues 133 comme montré à la Fig. 14E. Après insertion des broches $20c_1$ à $20c_{40}$ dans les fourreaux $11c_1$ à $11c_{40}$, une seconde pression vers le bas rapproche les branches des tétons 991 en descendant dans les alésages des bagues 133 (Fig. 14A). Puis les tétons s'élargissent et les collerettes 992 passent dessous les bagues 133 (Fig. 14B). A ce stade, les broches du boîtier $2c$ sont verrouillées dans les fourreaux du support $1c$.

Une troisième pression vers le bas sur le boîtier $2c$ provoque l'engagement des tétons 991 dans les rondelles 137 (Fig. 14C). Les flexions propres opposées des branches de part et d'autre de la fente 990 de chaque patte 93 permettent à la collerette respective 992 de solidariser momentanément la patte 99 avec la rondelle respective 137. Puis, suite à un relâchement du boîtier $2c$, la détente élastique des traverses $93_1$ à $93_4$ du couvercle entraîne vers le haut les pattes 99 et donc les rondelles 137 qui coulissent dans les chambres 136 et buttent contre les bagues 133 (Fig. 14D). Les rondelles 137 retombent au fond des chambres 136 et les tétons 991 montent ensuite dans les bagues 133 jusqu'à ce que les collerettes 992 pénètrent dans les gorges 134 grâce à l'élargissement des fentes 990 (Fig. 14E). Le boîtier $2c$ peut être alors retiré du couvercle 9.

En référence à nouveau à la Fig. 10, le couvercle 9 comporte deux lames flexibles conductrices de liaison $95_+$ et $95_-$, et une diode de blocage $D_1$. Les lames $95_+$ et $95_-$ s'étendent longitudinalement à partir des milieux des traverses $93_1$ et $93_2$ et dans les lumières $94_1$ et $94_2$ pour être appliquées sur la borne positive $40_1^+$ de la pile $4_1$ et la borne négative $40_2^-$ de la pile $4_2$ respectivement, comme montré à la Fig. 11F.

La diode $D_1$ est complètement enrobée dans la traverse $93_1$ entre le trou $91_1$ et la lame $95_+$. Un conducteur, en partie enrobé dans la traverse $93_1$ relie la lame $95_+$ à l'anode de la diode $D_1$, et présente un coude $91_T$ émergeant vers l'extérieur à partir du milieu de la traverse $93_1$, comme montré aux Figs. 10 et 15. Le coude $91_T$ sert de borne de test, comme la broche $10_T$ dans la Fig. 1.

La cathode de la diode $D_1$ est reliée à un conducteur $138_1$ noyé dans la traverse $93_1$ et ayant une extrémité plate verticale dirigée vers le bas $139_1$ sortant sous la traverse $93_1$ à proximité du trou $91_1$, comme montré aux Figs. 10 et 15. De même, la lame de liaison $95_-$ est reliée à un conducteur $138_2$ noyé dans la traverse $93_2$ et ayant une extrémité plate verticale $139_2$ sortant sous la traverse $93_2$ à proximité du trou $91_{21}$, comme montré à la Fig. 16. Les extrémités $139_1$ et $139_2$ sont destinées à être respectivement appliquées sur des lames de contact $111_1$ et $111_2$ des fourreaux $11c_1$ et $11c_2$ des broches d'alimentation $10c_1$ et $10c_{21}$, comme montré à la Fig. 12. Comme on le voit à la Fig. 17, la lame de contact $111_1$, $111_{21}$ est découpée dans l'une des deux lames du fourreau $11c_1$, $11c_{21}$ juste au-dessus de la broche d'alimentation $10c_1$, $10c_{21}$ et est cambrée sensiblement vers le haut. Lorsque le couvercle 9 est emboîté dans le support $1c$ entre les parois 121 et 122, les extrémités $139_1$ et $139_2$ s'appuient sur les lames de contact $111_1$ et $111_{21}$ respectivement, et simultanément, les lames de liaison $95_+$ et $95_-$ s'appuient sur la borne $40_1^+$ de la pile $4_1$ et sur la borne $40_2^-$ de la pile $4_2$, respectivement. Dans ces conditions, la borne $40_1^+$ de la pile $4_1$ est reliée à la broche d'alimentation positive $10c_1$ à travers la borne de test $91_T$, la diode $D_1$, le conducteur $138_1$, l'extrémité $139_1$ du conducteur $138_1$ et la lame de contact $111_1$ du fourreau $11c_1$, et la borne $40_2^-$ de la pile $4_2$ est reliée à la broche d'alimentation négative $10c_{21}$ à travers le conducteur $138_2$, l'extrémité $139_2$ du conducteur $138_2$ et la lame de contact $111_{21}$ du fourreau $11c_{21}$.

La structure du support $1c$ telle que décrite ci-dessus peut être adaptée à la forme, la disposition mutuelle des bornes de chaque pile et aux dimensions, telles qu'épaisseur, des piles. Divers exemples d'adaptation sont montrées aux Figs. 11A à 11H. Selon la Fig. 11E, le support $1c$ contient trois piles boutons ayant chacune une petite surface circulaire métallique saillante pour borne positive, analogue aux bornes négatives $40_1^-$ à $40_3^-$ des piles $4_1$ à $4_3$, et une grande surface cylindrique métallique pour borne négative, analogue aux bornes positives $40_1^+$ à $40_3^+$ des piles $4_1$ à $4_3$; dans ce cas, la coiffe 56 formant interrupteur reçoit la borne négative d'une pile logée dans la lumière $14c_1$, et les barrettes de liaison $5c_1$ et $5c_2$ sont retournées de 180°; des rainures 59S et 59H sont également prévues dans la traverse $13c_1$ pour recevoir le levier 58, comme montré à la Fig. 10. Les Figs. 11G et 11H correspondent respectivement aux Figs. 11E et 11F en remplaçant chaque pile par deux piles boutons deux fois moins épaisses que les piles des Figs. 11E et 11F; dans ce cas, les barrettes de liaison en équerre $5c_2$ selon la Fig. 11E et $5c_1$ selon la Fig. 11F sont respectivement remplacées par des barrettes de liaison $5c_2'$ et $5c_1'$ ayant chacune une portion verticale traversant la traverse intermédiaire correspondante $13c_4$ et $13c_3$ et deux portions horizontales aux extrémités de la portion verticale pour être appliquées par dessous et par dessus contre les bornes des piles minces inférieure et supérieure dans les lumières adjacentes $14c_2$ et $14c_3$, $14c_1$ et $14c_3$. Enfin, dans les Figs. 11A à 11D sont montrés des supports n'ayant que deux lu-

mières $14c_1$ et $14c_2$ contenant chacune une ou deux piles disposées respectivement d'une manière analogue aux piles d'extrémité dans les Figs. 11E à 11H.

Selon d'autres variantes, au lieu que des barrettes de liaison soient solidaires du support 1d, des barrettes de liaison peuvent être solidaires des traverses intermédiaires $93_3$ et $93_4$ du couvercle 9.

Les structures du support 1c et du couvercle 9 peuvent être sensiblement modifiées. Ainsi, chacune des lumières $14c_1$ à $14c_3$ et $94_1$ à $94_3$ peut être barrée par une traverse mince longitudinale ou transversale ou comportée un fond venant de moulage afin de former des cavités pour recevoir les piles. L'interrupteur de la source d'alimentation de secours peut être un coulisseau longitudinal ou vertical à extrémité métallisée remplaçant la coiffe 56.

On décrit maintenant une autre réalisation d'un support de boîtier de circuit intégré contenant, outre une source d'alimentation de secours à deux piles minces $4_1$ et $4_2$, un circuit de surveillance 7 de la charge de la source de secours en vue de signaler la décharge de la source de secours relativement à un seuil de tension prédéterminé.

Une première variante du support 1 selon ladite autre réalisation est illustrée à la Fig. 18. Le support 1 a une forme générale analogue au support déjà décrit en référence à la Fig. 1, bien que selon une autre variante, le support puisse être analogue au support 1c montré à la Fig. 10.

Dans la première lumière $14_1$ sont logées en superposition horizontale les deux piles boutons $4_1$ et $4_2$, la borne positive $40_2^+$ de la pile $4_2$ étant posée au-dessus de la borne négative $40_1^-$ de la pile $4_1$. La borne positive $40_1^+$ de la pile inférieure $4_1$ est reliée à la broche d'alimentation $10_1$ du support à travers la lame conductrice de liaison $15_+$ en forme de poêle et la diode $D_1$, la broche de test $10_T$ étant supprimée. La borne $40_1^+$ est également reliée à travers un conducteur $15_T$ à une borne de test BT du circuit de surveillance 7 qui est logé dans la seconde lumière $14_2$, comme on le verra dans la suite. Le conducteur 15T est de préférence noyé dans le support et contourne la lumière $14_1$ à travers la traverse $13_1$, le longeron $12_2$ et la traverse centrale $13_0$.

La barrette 5 de la Fig. 1 est remplacée par une barrette analogue ne comprenant que la demi-portion longitudinale entre l'extrémité $52_1$ et les deux pattes s'étendant vers le bas 51. L'extrémité horizontale $52_1$ est appliquée contre la borne négative $40_2^-$ de la pile supérieure $4_2$ et plaque les piles $4_1$ et $4_2$ contre la lame $15_+$ lorsque les deux pattes 51 sont enfichées dans les deux trous 131, ici métallisés, de la traverse centrale $13_0$. Les trous 131 sont reliés à la broche d'alimentation négative ou référée à la terre $10_{15}$ du support 1 et à une borne de terre BG du circuit 7 à travers un conducteur 15G de préférence noyé dans le support et contournant la lumière $14_2$ à travers la traverse $13_0$ et le longeron $12_2$.

A l'exception des modifications du support relatives à l'insertion du circuit de surveillance 7, tous les autres éléments du support tels que broches $10_1$ à $10_{28}$, fourreaux $11_1$ à $11_{28}$, pistes conductrices $16_+$ et $16_-$, cosses $17_+$ et $17_-$, et feuille isolante 54 dans la Fig. 18 sont analogues à ceux décrits en référence à la Fig. 1, respectivement.

Le bloc-diagramme du circuit de surveillance 7 est montré à la Fig. 19. Le circuit 7 comprend essentiellement un oscillateur commandé en tension 70 oscillant à une fréquence variable dans la gamme des fréquences audibles, un circuit de commande 71 commandant l'oscillateur 70, et un circuit de signalisation 72.

L'oscillateur 70 comprend un circuit trigger de Schmitt 701 à résistance de contre-réaction 702 et à condensateur variable sous la forme d'une diode varicap 703 reliée à la borne BG. Une entrée de l'oscillateur est constituée par une borne 704 commune à la résistance 702 et à la diode vericap 703. La borne 704 est reliée à la borne de test BT, et donc à la borne positive $40_1^+$ de la source de secours $4_1$ - $4_2$, à travers une résistance 73 en série avec une diode polarisée directement 74. La fréquence du signal à une sortie 705 du circuit trigger 701 est inversement proportionnelle au paramètre RC de la résistance constante 702 et de la capacité variable de la diode varicap 703, et est donc inversement proportionnelle à la tension appliquée à la borne de test BT.

Le circuit de commande 71 est constitué essentiellement par une bascule 711 du type RS. Une entrée R de la bascule 711 est reliée à une borne de remise à zéro BRZ du circuit 7. Une autre entrée S de la bascule 711 est reliée à une borne de validation BV du circuit 7. Une sortie Q de la bascule 711 est reliée à une entrée de déclenchement 706 du circuit trigger 701. Les bornes BV et BRZ ainsi qu'une borne de sortie BS du circuit 7 sont reliées à un microprocesseur (non représenté) implanté sur la carte de circuit imprimé 3 à travers des conducteurs respectifs $15_V$, $15_{RZ}$ et $15_S$ noyés dans le support 1 au niveau de la seconde lumière $14_2$ et à travers des broches supplémentaires respectives $10_V$, $10_{RZ}$ et $10_S$, comme montré à la Fig. 18. Le microprocesseur ou autre circuit équivalent à celui-ci permet d'interroger le circuit de surveillance en vue de signaler une décharge de la source de secours. L'interrogation est effectuée lorsque le microprocesseur n'accomplit pas d'autres tâches prioritaires, ou périodiquement selon l'organisation des autres circuits implantés sur la carte imprimée.

L'interrogation par le microprocesseur est transmise sous la forme d'une impulsion négative fugitive à la borne BRZ afin d'initialiser la bascule 711. Puis périodiquement, une impulsion négative fugitive est appliquée sur la borne BV par le microprocesseur afin de valider le circuit trigger 701 en appliquant un «1» sur l'entrée 706. Si la tension de la source de secours à la borne BT est supérieure au seuil de tension prédéterminé, typiquement égal à 2,5 volts pour deux piles fonctionnant normalement chacune avec 1,5 volt, l'oscillateur 70 demeure bloqué et aucun signal oscillant n'est détecté par le microprocesseur à la sortie BS. Par contre, si la tension à la borne BT est inférieure au seuil prédéterminé, ce qui correspond à une phase de décharge des deux piles de secours, un signal à fréquence audible est délivré par la borne 705 de l'oscillateur 70 vers la borne BS et excite le circuit de signalisation 72. Le circuit 72 avertit que la source de secours sera bientôt défaillante, le seuil de tension prédéterminé étant choisi sensiblement supérieur à la tension minimale de maintien de la source de secours. L'état de la borne BRZ n'est pas modifié par le microprocesseur en réponse au signal oscillant. Dans le cas contraire, le microprocesseur délivre une impulsion fugitive sur la borne BRZ pour remettre à zéro la bascule 711 qui bloque l'oscillateur 70, ce qui évite toute décharge intempestive de la source de secours $4_1$ - $4_2$.

Le circuit de signalisation 72 comprend un transducteur électro-acoustique 721 tel qu'un haut-parleur miniature sous la forme d'un buzzer à barreau piézo-électrique. Des bornes 722 et 723 du transducteur 721 sont reliées à la borne référée à la terre BG et, à travers un inverseur 724, aux bornes 705 et BS, respectivement. Optionellement le circuit 70 peut comprendre un dispositif de visualisation 725, tel qu'une barrette de cristaux liquides ou de diodes électroluminescentes. Le dispositif de visualisation est alors connecté entre la sortie 70 de l'oscillateur 70 et la borne BS reliée à l'entrée de l'inverseur 724.

Le circuit de surveillance 7 comprend également d'autres éléments, tels que des résistances de polarisation 712, 713 et 726 reliées respectivement aux bornes BRZ, BV et BS et portées à une tension positive par une borne commune BP. La borne BP est reliée à la carte 3 à travers un conducteur $15_P$ noyé dans le support 1 comme montré à la Fig. 18.

Le circuit de surveillance 7 peut être fabriqué sous la forme d'un circuit intégré enfermé dans un boîtier ou sous une forme hybride d'éléments discrets implantés sur une petite carte de circuit imprimé. Les Figs. 20, 21 et 22 illustrent un exemple de réalisation du boîtier du circuit de surveillance 7 constitué par une embase discoïde isolante 75 et un capot métallique ou plastique cylindrique 76. Un support 77 du circuit intégré ou discret de surveillance 7 est collé sur une face interne de l'embase 75. Six petites queues verticales conductrices constituent les bornes BG, BS, BV, BP, BRZ et BT et sont enfichées dans des trous métallisés respectifs d'un fond de la lumière $14_2$ du support 1, formant ici un réceptacle circulaire du boîtier 75-76 ayant typiquement un diamètre de 2,5 cm. Les trous métalliques précédents constituent les extrémités des conducteurs $15_G$, $15_S$, $15_V$, $15_P$, $15_{RZ}$ et $15_T$. Selon une autre variante, les queues du boîtier 75-76 relatives aux bornes BS, BV, BP et BRZ remplacent les broches $10_S$, $10_V$, $10_P$ et $10_{RZ}$ et traversent le fond de la cavité $14_2$. Dans une partie de la périphérie circulaire du capot 76 sont prévus des trous pour l'emplacement du dispositif de visualisation 725, tel que des diodes électroluminescentes montrées aux Figs. 21 et 22.

Le buzzer piézoélectrique 721 peut constituer la majeure partie du dessus du capot 76 et avoir ses bornes 722 et 723 sous forme de fils logés dans le boîtier et soudés au support 77, comme montré aux Figs. 20 et 21. Selon une autre variante montrée à la Fig. 18, le buzzer 721 contenant l'inverseur 724 est plaqué sur un ruban adhésif 780 solidaire d'une pince en U 78. Des pattes recourbées vers le bas 781 de la pince 78 sont crochetées aux extrémités du boîtier de circuit intégré 2. Les bornes 722 et 723 du buzzer sont constituées par des fils souples soudés ou pincés aux broches $10_{15}$ et $10_S$ du support 1.

Selon une autre variante montrée à la Fig. 23, un circuit de commande commun 71 surveille un grand nombre de sources d'alimentation de secours, par exemple au nombre de six $AS_1$ à $AS_6$. Chaque source d'alimentation $AS_1$ à $AS_6$ est logée dans la première lumière $14_1$ d'un support respectif $1_1$ à $1_6$ de boîtier de circuit intégré analogue au support 1 montré à la Fig. 18. La seconde lumière $14_2$ du support sous la forme d'une cavité inclut un circuit de surveillance hybride ou intégré $7_1$ à $7_6$ comprenant un oscillateur $70_1$ à $70_6$, une résistance $73_1$ à $73_6$ et une diode $74_1$ à $74_6$ analogues à ceux décrits en référence à la Fig. 19, ainsi que d'autres éléments $727_1$ à $727_6$, $728_1$ à $728_6$, et $729_1$ à $729_6$. Le circuit hybride ou intégré comprend également un dispositif de visualisation $725_1$ à $725_6$, tel que des diodes électroluminescentes ou une barrette de cristaux liquides interconnectée entre la borne positive BP et la sortie $705_1$ à $705_6$ de l'oscillateur $70_1$ à $70_6$ à travers un inverseur $727_1$ à $727_6$ et une résistance $728_1$ à $728_6$. Un élément non inverseur $727'_1$ à $727'_6$ et le dispositif de visualisation $725_1$ à $725_6$ peuvent être reliés convenablement en série à la borne de terre BG selon une autre variante montrée à la Fig. 24.

L'un des supports $1_1$ à $1_6$, tel que le support $1_1$ relatif au circuit $7_1$ montré à la Fig. 15, inclut également le circuit de commande 71 à bascule RS 711, le buzzer piézoélectrique 721, deux commutateurs 714 et 715 et deux résistances de polarisation 716 et 717. La sortie Q de la bascule 711 est reliée aux entrées de déclenchement $706_1$ à $706_6$ des oscillateurs $70_1$ à $70_6$. La borne 723 du buzzer commun 721 est reliée aux sorties $705_1$ à $705_6$ des oscillateurs $70_1$ à $70_6$ à travers les commutateurs $729_1$ à $729_6$. Les commutateurs $729_1$ à $729_6$, 714 et 715 sont des portes en technologie CMOS. Les différentes connexions entre les six circuits $7_1$ à $7_6$ supportés par les supports sont réalisées à travers des broches de support et des conducteurs de la carte imprimée 3.

Le fonctionnement du circuit de surveillance montré à la Fig. 23 est le suivant. Une impulsion négative fugitive appliquée à la borne BRZ initialise la bascule 711 qui ferme les portes 714 et 715. Puis une impulsion de validation appliquée à la borne BV change l'état de la bascule 711 qui valide les circuits triggers $701_1$ à $701_6$ des oscillateurs $70_1$ à $70_6$ et ouvre les portes 714 et 715. Une seconde entrée de la porte 714 étant reliée à la borne de tension positive BP à travers la résistance 716, une sortie de la porte 714 applique une tension positive à des entrées des portes $729_1$ à $729_6$ et à une autre entrée de la porte 715. D'autres entrées des portes $729_1$ à $729_6$ sont reliées respectivement aux sorties $705_1$ à $705_6$ des oscillateurs $70_1$ à $70_6$. Si aucune source d'alimentation de secours $AS_1$ à $AS_6$ ne produit une tension inférieure au seuil de tension prédéterminé, les portes $729_1$ à $729_6$ et 715 demeurent fermées et la tension à la borne de sortie BS n'est pas modifiée.

Dans le cas où une source d'alimentation de secours $AS_1$ à $AS_6$ produit une tension inférieure au seuil de tension prédéterminé et est donc en cours de décharge, un signal à fréquence audible est délivré par la sortie $705_1$ à $705_6$ de l'oscillateur correspondant $70_1$ à $70_6$. Le signal à fréquence audible active l'illumination du dispositif de visualisation correspondant $725_1$ à $725_6$ et ouvre au rythme de la fréquence audible la porte correspondante $729_1$ à $729_6$. La tension positive appliquée par la porte 714 excite le buzzer 721 à travers la porte correspondante $729_1$ à $729_6$. Compte tenu de l'impédance du buzzer 721, la sortie BS de la porte 715 présente au rythme de la fréquence audible des tensions référées à la terre. Le signal alternatif à la sortie BS est alors traité par le microprocesseur et indique une anomalie de tension de l'une des six sources d'alimentation de secours $AS_1$ à $AS_6$.

Selon une autre variante, un circuit de surveillance comprend l'ensemble des circuits $7_1$ à $7_6$ de la Fig. 23 et est complètement supporté par un même support tel que le support relatif au circuit $7_1$, qui comporte alors cinq broches de test reliées à travers la carte imprimée aux bornes positives des sources d'alimentation $AS_2$ à $AS_6$ incluses dans les cinq autres supports.

Selon une autre réalisation, le boîtier de circuit intégré ou hybride 75-76 dans la cavité $14_2$ du support 1 montré au Figs. 18 et 20 à 22 inclut également un circuit d'inhibition 8. Le circuit 8 inhibe une fonction prédéterminée du circuit intégré contenu dans le boîtier 2 lorsque la tension de la source d'alimentation principale AP disparaît. Si le circuit intégré dans le boîtier 2 est une mémoire, la fonction prédéterminée à inhiber est l'autorisation d'écriture dans la mémoire, par exemple.

Comme montré à la Fig. 25, le circuit d'inhibition 8 comprend deux transistors NPN 80 et 81 ayant des émetteurs reliés à la borne BG référée à la terre. Des collecteurs des transistors 80 et 81 sont reliés respectivement à travers des résistances 82 et 83 à la borne commune des diodes de blocage $D_1$ et $D_2$ déjà mentionnées en référence à la Fig. 3. Le collecteur du transistor 80 est relié à une base du transistor 81. Une base du transistor 80 est reliée à la borne de tension positive $AP_+$ de la source d'alimentation principale AP à surveiller, à travers une résistance 84 et une broche supplémentaire (non représentée) du support 1. Le collecteur du transistor 81 est reliée à la borne BP à travers une diode 85 et une résistance 86. Une anode de la diode 85 et une borne de la résistance 86 est désignée par une borne commune 87 à relier à une entrée d'inhibition de fonction du circuit intégré du boîtier 2 à travers une broche supplémentaire (non représentée) du support 1.

Lorsque la source d'alimentation principale AP délivre normalement une tension, la tension positive à la borne $AP_+$ sature le premier transistor 80 et bloque le second transistor 81. La tension sur le collecteur du transistor 81 est positive, ce qui ne produit aucune masse active à la borne 87.

Lorsque la tension de la source d'alimentation principale disparaît, la source de secours $4_1$ - $4_2$ relaye la source principale AP en appliquant une tension d'alimentation à travers la diode $D_1$. Par contre, la disparition de la tension positive à la borne $AP_+$ bloque le transistor 80. La tension positive sur le collecteur du transistor 80 sature le second transistor 81 et la diode 85 devient conductrice. Une masse active est ainsi présente à la borne 87 qui commande l'inhibition de la fonction prédéterminée du circuit intégré dans le boîtier 2.

## Revendications

1. Support de boîtier de circuit intégré comprenant des broches conductrices ($10_1$ à $10_{28}$), sous-jacentes au support (1), dans lesquelles s'enfichent des broches conductrices ($20_1$ à $20_{28}$) du boîtier (2), caractérisé en ce qu'il comprend un logement ($14_1$ et/ou $14_2$) pour recevoir une source d'alimentation de secours amovible ($4_1$ - $4_2$) à interconnecter entre deux broches prédéterminées ($10_1$, $10_{15}$) du support (1) dans lesquelles s'enfichent des broches d'alimentation ($20_1$, $20_{15}$) du boîtier de circuit intégré (2).

2. Support conforme à la rivendication 1, caractérisé en ce que le logement ($14_1$ et/ou $14_2$) est situé de préférence entre deux rangées parallèles de broches ($10_1$ à $10_{14}$, $10_{15}$ à $10_{28}$) du support (1).

3. Support conforme à la revendication 1 ou 2, caractérisé en ce que la source d'alimentation de secours ($4_1$ - $4_2$) est composée de plusieurs sorces d'alimentation élémentaires connectées en série, telles que piles ou accumulateurs miniatures du type bouton ($4_1$, $4_2$).

4. Support conforme à la revendication 3, caractérisé en ce que les sources d'alimentation élémentaires sont réparties en au moins deux batteries juxtaposées ($4_1$, $4_2$) ayant chacune des première et seconde bornes superposées, et en ce que le support (1; 1a; 1b) comprend deux conducteurs de liaison ($15_+$, $15_-$; $15a_-$; $15b_+$, $15b_-$) ayant des premières extrémités reliées respectivement aux broches prédéterminées ($10_1$, $10_{15}$; $10_1$, $10_8$), et des secondes extrémités, de préférence sous forme de lame conductrice flexible, plaquées respectivement contre des premières bornes de polarités opposées ($40_1^+$, $40_2^-$) de deux batteries ($4_1$, $4_2$) formant des bornes de la source d'alimentation de secours ($4_1$ - $4_2$), et au moins un troisième conducteur de liaison (5; 5a, 5b) ayant des extrémités ($52_1$, $52_2$) plaquées contre des secondes bornes de polarités opposées ($40_1^-$, $40_2^+$) de deux batteries ($4_1$, $4_2$).

5. Support conforme à la revendication 4, caractérisé en ce que le troisième conducteur de liaison (5) est un élément conducteur amovible du support (1).

6. Support conforme à la revendication 4, caractérisé en ce que les secondes extrémités desdits deux conducteurs de liaison ($15_+$, $15_-$; 63) sont des éléments conducteurs amovibles du support (1; 1a).

7. Support conforme à l'une quelconque des revendications 1 à 3, caractérisé en ce que le support (1) comprend deux conducteurs de liaison ($15_+$; $52_1$, $15_G$) ayant des premières extrémités reliées respectivement aux broches prédéterminées ($10_1$, $10_{15}$), et des secondes extrémités, de préférence sous forme de lame conductrice flexible, plaquées respectivement contre des bornes ($40_1^+$, $40_2^-$) de la source d'alimentation de secours ($4_1$ - $4_2$).

8. Support conforme à l'une quelconque des revendications 4 à 7, caractérisé en ce que les premières extrémités desdits deux conducteurs de liaison ($15_+$, $15_-$; $15_+$, $52_1$, $15_G$) sont noyées dans le support (1).

9. Support conforme à la revendication 7 ou 8, caractérisé en ce que l'une des secondes extrémités desdits deux conducteurs de liaison (63, Fig. 7; $52_1$, Fig. 18) est un élément conducteur amovible du support (1).

10. Support conforme à l'une quelconque des revendications 5, 6 et 9, caractérisé en ce que ledit élément conducteur amovible (5; $52_1$) est enfichable dans le support (1).

11. Support conforme à l'une quelconque des revendications 5, 6, 9 ou 10, caractérisé en ce que ledit élément conducteur amovible (5; $52_1$) est fixé sous le boîtier de circuit intégré (2), de préférence par collage.

12. Support conforme à l'une quelconque des revendications 5, 6 ou 9, caractérisé en ce que ledit élément conducteur amovible (63) est fixé contre une face interne d'un couvercle ($6_2$) fermant tout ou partie du logement ($14_1$ et/ou $14_2$) du support (1a) contenant la source d'alimentation de secours ($4_1$ - $4_2$).

13. Support conforme à la revendication 12, caractérisé en ce que le couvercle ($6_2$) est fixé au support (1a) par une fermeture à baïonnette (61, 62, 141, 142, 143, 144).

14. Support conforme à l'une quelconque des revendications 1 à 13, caractérisé en ce que des bornes ($40_1^+$, $40_2^-$) de la source d'alimentation de secours ($4_1^-$, $4_2$; Figs. 1, 7, 10) sont parallèles à des grandes faces du boîtier de circuit intégré (2) et à des grandes faces du support (1, 1a).

15. Support conforme à l'une quelconque des revendications 1 à 10 et 12, caractérisé en ce que des bornes ($40_1^+$, $40_2^-$) de la source d'alimentation de secours ($4_1$ - $4_2$); Figs. 8, 9) sont perpendiculaires à des grandes faces du boîtier de circuit intégré et à des grandes faces du support (1b).

16. Support conforme à la revendication 15, caractérisé en ce qu'il est associé à un couvercle (6b) amovible ou articulé au support (1b) et fermant une cavité (14b) contenant la source d'alimentation de secours ($4_1$ - $4_2$).

17. Support conforme à l'une quelconque des revendications 1 à 3, caractérisé en ce qu'il est associé à un couvercle (9) amovible du support (1c), intercalé entre le boîtier de circuit intégré (2c) et le support (1c) et recouvrant au moins en partie la source d'alimentation de secours ($4_1$ - $4_3$ - $4_2$), ledit couvercle ayant des trous ($91_1$ à $91_{40}$) pour recevoir des moyens ($11c_1$ à $11c_{40}$) pour connecter les broches ($20c_1$ à $20c_{40}$) du boîtier de circuit intégré (2c) aux broches ($10c_1$ à $10c_{40}$) du support (1c).

18. Support conforme à la revendication 17, caractérisé en ce que les moyens dans chaque trou ($91_1$ à $91_{40}$) pour connecter une broche ($20c_1$ à $20c_{40}$) du boîtier de circuit intégré à une broche ($10c_1$ à $10c_{20}$) du support (1c) comprennent deux lames conductrices flexibles ($11c_1$ à $11c_{40}$) fixées à la broche ($10c_1$ à $10c_{40}$) du support (1c) et pénétrant à glissement par une première extrémité du trou, la broche ($20c_1$ à $20c_{40}$) du boîtier de circuit intégré (2c) pénétrant par une seconde extrémité du trou et entre lesdites deux lames flexibles ($11c_1$ à $11c_{40}$).

19. Support conforme à la revendication 17 ou 18, caractérisé par des moyens ($98_1$, $98_2$, $131_1$, $131_2$) pour verrouiller le couvercle (9) au support (1c).

20. Support conforme à la revendication 19, caractérisé en ce que les moyens pour verrouiller ($98_1$, $98_2$, $131_1$, $131_2$) servent également à pincer les broches ($20c_1$ à $20c_{40}$) du boîtier du circuit intégré (2c) dans les moyens pour connecter ($11c_1$ à $11c_{20}$) après que le couvercle ait été verrouillé au support (1c).

21. Support conforme à la revendication 17 ou 18, caractérisé par des premiers moyens ($982_1$, $982_2$, $131_1$, $131_2$) pour verrouiller le couvercle (9) au support (1c) suite à une première pression exercée sur le couvercle vers le support afin de maintenir la source d'alimentation de secours ($4_1$ - $4_3$ - $4_2$) dans le support, et par des secondes moyens ($981_1$, $981_2$, $131_1$, $131_2$) pour pincer les broches ($20c_1$ à $20c_{40}$) du boîtier (2c) dans les moyens pour connecter ($11c_1$ à $11c_{20}$) suite à une seconde pression exercée sur le boîtier vers le couvercle verrouillé au support.

22. Support conforme à l'une quelconque des revendications 19 à 21, caractérisé en ce que les moyens pour verrouiller comprennent au moins une patte flexible ($98_1$) solidaire d'une traverse flexible convexe ($93_1$) du couvercle (9) et munie d'une nervure ($982_1$), ladite traverse ayant un sommet propre à être poussé par le boîtier de circuit intégré (2c) et étant fixée à deux longerons ($92_1$, $92_2$) du couvercle (9), les longerons étant dotés desdits trous ($91_1$ à $91_{40}$) et étant appliqués contre le support (1c), et en ce que les moyens pour verrouiller comprennent également un orifice ($131_1$) pratiqué dans le supoport (1c) pour recevoir la nervure ($982_1$) de la patte ($98_1$) afin de verrouiller le couvercle (9) au support (1c) suite à une première pression exercée sur le couvercle en direction du support, une seconde pression exercée sur le boîtier (2c) en direction du couvercle (9) verrouillé au support (1c) dégageant la nervure ($982_1$) de l'orifice ($131_1$) et passant la nervure ($982_1$) sous ladite traverse ($93_1$) afin de pincer les broches ($20c_1$ à $20c_{40}$) du boîtier de circuit intégré (2c) dans les moyens pour connecter ($11c_1$ à $11c_{40}$), grâce à une diminution de la convexité du sommet de la traverse ($91_1$) du couvercle (9) et un sensible écartement des longerons ($92_1$, $92_2$).

23. Support conforme à l'une quelconque des revendications 19 ou 21, caractérisé en ce que les moyens pour verrouiller (99, 132) sont tels qu'une première pression exercée sur le couvercle (9) entraîne un verrouillage du couvercle au support (1c), une seconde pression exercée sur le boîtier de circuit intégré (2c) entraîne un pincement des broches ($20c_1$ à $20c_{40}$) du boîtier de circuit intégré (2c) dans les moyens pour connecter ($11c_1$ à $11c_{40}$), et une troisième pression exercée sur le boîtier de circuit intégré (2c) entraîne un dégagement des broches ($20c_1$ à $20c_{40}$) du boîtier, des moyens pour connecter ($11c_1$ à $11c_{40}$) sans déverrouiller le couvercle (9) du support (1).

24. Support conforme à la revendication 23, caractérisé en ce que les moyens pour verrouiller (99, 132) comprennent au moins une patte flexible (99) solidaire d'une traverse flexible ($98_1$) du couvercle, de préférence fendue (990), ayant une extrémité (999) surmontée d'une collerette (992), ladite traverse ayant un sommet propre à être poussé par le boîtier de circuit intégré (2c) et étant fixée à deux longerons ($92_1$, $92_2$) du couvercle, les longerons étant dotés desdits trous ($91_1$ à $91_{40}$) et étant appliqués contre le support (1c), et en ce que les moyens pour verrouiller comprennent également deux trous (132) dans le support (1c), chaque trou ayant une extrémité sous la patte (99) du couvercle (9) contenant une bague fixe (133) à gorge (134) et une chambre (136) contenant une rondelle mobile librement (137), ladite première pression introduisant la collerette (992) dans la gorge (134), la dite seconde pression introduisant l'extrémité de la patte (999) dans la chambre (136) et la collerette (992) sous la bague (133), et ladite troisième pression introduisant l'extrémité de la patte (999) dans les rondelles (137) et la prise de celles-ci par la collerette (992), puis la patte (93) remontant dans la chambre (136), libérant la rondelle (137) butant contre la bague (133), et étant stoppée dans la bague (133) par l'introduction de la collerette (992) dans la gorge (134), grâce à l'élasticité propre de la traverse ($98_1$, $98_2$) du couvercle (9) dirigée vers le boîtier (2c).

25. Support conforme à l'une quelconque des revendications 1 à 3 et 17 à 24, caractérisé en ce qu'il est associé à un couvercle (9) amovible du support (1c), intercalé entre le boîtier de circuit intégré (2c) et le support (1c) et recouvrant au moins en partie la source d'alimentation de secours ($4_1$), ledit couvercle (9) comprenant un conducteur ($138_1$) ayant une première extrémité ($139_1$) émergeant sous le couvercle (9) et applicable entre une portion ($111_1$) de l'une des broches prédéterminées ($10c_1$) du support (1c) et ayant une seconde extrémité ($95_+$), de préférence sous forme de lame conductrice flexible, applicable contre l'une de bornes ($40_1^+$) de la source d'alimentation de secours, ledit support (1c) comprenant un conducteur ($5c_1$) ayant une première extrémité reliée à l'autre broche prédéterminée ($10c_{21}$) du support (1c) et ayant une seconde extrémité, de préférence sous forme de lame conductrice flexible, applicable contre l'autre borne ($40_1^-$) de la source d'alimentation de secours.

26. Support conforme à l'une quelconque des revendications 1, 2 et 24, caractérisé en ce qu'il est associé à un couvercle (9) amovible du support (1c), intercalé entre le boîtier de circuit intégré (2c) et le support (1c) et recouvrant au moins en partie la source d'alimentation de secours ($4_1$ - $4_3$ - $4_2$), ledit couvercle (9) comprenant deux conducteurs ($138_1$, $138_2$) ayant chacun une première extrémité et une seconde extrémité, les premières extrémités ($139_1$, $139_2$) desdits conducteurs émergeant sous le couvercle (9) et étant applicables contre des portions ($111_1$, $111_{21}$) des broches prédéterminées ($10c_1$, $10c_{21}$) du support (1c) respectivement et les secondes extrémités ($95_+$, $95_-$) desdites conducteurs, de préférence sous forme de lame conductrice flexible, étant applicables contre des bornes ($40_1^+$, $40_2^-$) de la source d'alimentation de secours ($4_1$ - $4_3$ - $4_2$).

27. Support conforme à la revendication 26, caractérisé en ce que la source d'alimentation de secours ($4_1$ - $4_3$ - $4_2$) comprend au moins deux batteries juxtaposées ($4_1$, $4_2$) et comprenant chacune une ou plusieurs sources d'alimentations élémentaires superposées, telles que piles ou accumulateurs miniatures, ledit support (1c) ou ledit couvercle (9) comprenant au moins un conducteur de liaison ($5c_1$, $5c_2$), de préférence sous forme de lame conductrice flexible, pour relier en série deux batteries juxtaposées adjacentes ($4_1$, $4_3$; $4_3$, $4_2$).

28. Support conforme à l'une quelconque des revendications 1 à 27, caractérisé en ce qu'il comprend des moyens (56) pour déconnecter la source d'alimentation de secours ($4_1$ - $4_3$ - $4_2$) des broches prédéterminées ($20c_1$, $20c_2$) du support (1c) sans retirer un quelconque élément du support (1c).

29. Support conforme à la revendication 28, caractérisé en ce que la source d'alimentation de secours ($4_1$ - $4_3$ - $4_2$) comprend au moins une source d'alimentation élémentaire ($4_2$), telle qu'une pile bouton, ayant une borne discoïde ($40_2^+$), et en ce que les moyens pour déconnecter comprennent un élément cylindrique isolant électriquement (56) ayant des segments périphériques (57) enserrant ladite borne discoïde ($40_2^+$) et un levier (58), ledit levier étant à une première position (59S) à laquelle un conducteur flexible ($5c_2$) relié à l'une des broches prédéterminées ($10c_1$) est plaqué contre ladite borne discoïde ($40_2^+$), et, suite à une rotation dudit élément isolant (56) dans le support (1c), à une seconde position (59H) à laquelle le conducteur flexible ($5c_2$) est plaqué contre l'un des segments (57) afin de déconnecter ladite borne discoïde ($40_2^+$) de ladite broche prédéterminée ($10c_1$).

30. Support conforme à l'une quelconque des revendications 1 à 29, caractérisé en ce que ladite source d'alimentation de secours comprend plusieurs batteries juxtaposées de source élémentaires reliées en série, telles que piles ou accumulateurs du type bouton ($4_1$, $4_2$, $4_3$), et en ce que le support (1, 1c) comprend plusieurs logements séparés ($14c_1$, $14c_2$, $14c_3$), telles que lumières ou cavités à fond, pour recevoir respectivement les batteries ($4_1$, $4_2$, $4_3$) lesdites logements ayant une section de préférence analogue à celle des batteries.

31. Support conforme aux revendications 29 et 30, caractérisé en ce que l'élément cylindrique isolant (56) est monté à rotation dans l'un desdits logements ($14c_2$) et en ce que le levier (58) est flexible, s'encastre dans deux rainures (59S, 59M) du support respectivement pour les deux positions et déborde du support (1c).

32. Support conforme à l'une quelconque des revendications 1 à 31, caractérisé en ce qu'il comprend une feuille isolante (54) sous-jacente au support (1) et traversée par les broches ($10_1$ à $10_{28}$) du support (1).

33. Support conforme à l'une quelconque des revendications 1 à 32, caractérisé en ce qu'il comprend une diode ($D_1$), de préférence noyée dans le support (1) ou dans un couvercle (9) recouvrant au moins en partie le support (1c), interconnectée entre l'une des broches prédéterminées ($10_1$) du support

et une borne $(40_1^+)$ de la source d'alimentation de secours $(4_1 - 4_2)$.

34. Support conforme à la revendication 33, caractérisé en ce qu'il comprend une broche supplémentaire $(10_T)$ sous-jacente au support (1), ou un coude conducteur $(91_T)$ saillant du couvercle (9) relié à ladite borne $(40_1^+)$ de la source d'alimentation de secours $(4_1 - 4_2)$ et à ladite diode $(D_1)$.

35. Support conforme à l'une quelconque des revendications 1 à 34, caractérisé en ce qu'il comprend deux pistes conductrices $(16_+, 16_-)$, de préférence sur deux chants parallèles du support (1), et deux éléments conducteurs de liaison $(17_+, 17_-)$ ayant chacun une extrémité fixée à l'une des deux broches prédéterminées $(10_1, 10_{15})$ et une extrémité fixable, de préférence par soudure, à l'une des pistes conductrices $(16_+, 16_-)$.

36. Ensemble de supports supportant chacun un boîtier de circuit intégré, conformes à la revendications 35, caractérisé en ce qu'uniquement un support (1A) comprend une source d'alimentation de secours $(4_1 - 4_2)$ et a ses pistes conductrices $(16_+, 16_-)$ respectivement reliées aux pistes conductrices des autres supports (1B, 1C) à travers des straps $(ST_+, ST_-)$.

37. Support conforme à l'une quelconque des revendications 1 à 35, caractérisé en ce qu'il comprend des moyens de surveillance (7) pour détecter une tension aux bornes $(40_1^+, 40_2^-)$ de la source d'alimentation de secours $(4_1 - 4_2)$ inférieure à un seuil de décharge prédéterminé.

38. Support conforme à la revendication 37, caractérisé en ce que les moyens de surveillance (7) sont sous forme hybride ou intégré, sont logés dans un boîtier (75-76) de préférence amovible du support (1) et sont connectés notamment à des broches supplémentaires $(10_S, 10_V, 10_P, 10_{RZ})$ du support.

39. Support conforme à la revendication 37 ou 38, caractérisé en ce que les moyens de surveillance comprennent un oscillateur (70), de préférence à fréquence audible, commandé par la tension aux bornes $(40_1^+, BT; 40_2^-, BG)$ de la source d'alimentation de secours $(4_1 - 4_2)$, et des moyens de signalisation (72) excité par un signal (705) sortant de l'oscillateur (70) en réponse au déblocage de l'oscillateur (70) par une tension aux bornes de la source d'alimentation de secours inférieure au seuil prédéterminé.

40. Support conforme à la revendication 39, caractérisé en ce que la fréquence du signal sortant de l'oscillateur (70) est inversement proportionnelle à la tension aux bornes $(40_1^+, BT; 40_2^-, BG)$ de la source d'alimentation de secours $(4_1 - 4_2)$.

41. Support conforme à la revendication 39 ou 40, caractérisé en ce que les moyens de signalisation (72) comprennent un dispositif de visualisation (725), tel que des diodes électroluminescentes ou une barrette à cristaux liquides.

42. Support conforme à l'une quelconque des revendications 39 à 41, caractérisé en ce que les moyens de signalisation (72) comprennent un transducteur électro-acoustique (721) de préférence tel qu'un buzzer piézoélectrique miniature.

43. Support conforme à la revendication 42, caractérisé en ce que le transducteur électro-acoustique (721) est fixable sur le boîtier de circuit intégré (2).

44. Support conforme à l'une quelconque des revendications 39 à 43, caractérisé en ce que les moyens de surveillance (7) comprennent des moyens (71) pour déclencher périodiquement l'oscillateur (70).

45. Support conforme à l'une quelconque des revendications 1 à 44, caractérisé en ce qu'il comprend des moyens (8) pour inhiber une fonction prédéterminée du circuit intégré (2) lorsque la tension d'une source d'alimentation principale (AP) entre lesdites broches d'alimentation $(20_1; 20_{15}, BG)$ disparaît.

46. Support conforme à la revendication 45, caractérisé en ce que les moyens pour inhiber (8) comprennent un premier transistor (80) ayant une base reliée à la borne positive $(AP_+)$ de la source d'alimentation principale (AP) de préférence à travers une résistance (84), et un second transistor (81) ayant une base reliée au collecteur du premier transistor (80) et un collecteur relié à une borne d'inhibition (87) du circuit intégré (2) de préférence à travers une diode (85), les collecteurs des transistors (80, 81) étant reliés chacun aux bornes positives de la source d'alimentation principale (AP) et de la source de secours $(4_1 - 4_2)$ de préférence à travers une résistance (82, 83) et des diodes $(D_2, D_1)$.

47. Ensemble de supports supportant chacun un boîtier de circuit intégré, implantés sur une carte de circuit imprimé (3), caractérisé en ce que les supports $(1_1 \text{ à } 1_6, 7_1 \text{ à } 7_6)$ sont conformes à la revendication 41 et en ce que l'un des supports $(1_1, 7_1)$ est conforme à la revendication 42 ou 43, ledit transducteur électro-acoustique (721) étant relié aux sorties $(705_1 2 \text{ à } 705_6)$ des oscillateurs $(70_1 \text{ à } 70_6)$ supportés par tous les supports à travers des portes logiques $(729_1 \text{ à } 729_6)$.

48. Ensemble de supports supportant chacun un boîtier de circuit intégré, implantés sur une carte de circuit imprimé (3), caractérisé en ce que les supports $(1_1 \text{ à } 1_6)$ sont conformes à l'une des revendications 1 à 36 et en ce que l'un des supports $(1_1, 7_1)$ est conforme à la revendication 42 ou 43, les moyens de surveillance (7) supportés par ledit support conforme à la revendication 42 ou 43 comprenant, associés à la source d'alimentation de secours $(AS_1 \text{ à } AS_6)$ de chacun des supports, un oscillateur $(70_1 \text{ à } 70_6)$ et des moyens de signalisation $(725_1 \text{ à } 726_6)$ conformes à l'une des revendications 39 à 41.

49. Ensemble de supports conforme à la revendication 47 ou 48, caractérisé en ce que l'un des supports $(1_1, 7_1)$ comprend des moyens (71) pour déclencher périodiquement les oscillateurs $(70_1 \text{ à } 70_6)$ et des moyens (714, 715) pour délivrer l'un des signaux sortant des oscillateurs $(70_1 \text{ à } 70_6)$ lorsque la tension aux bornes de la source d'alimentation de secours correspondante $(AS_1 \text{ à } AS_6)$ est inférieure au seuil de décharge prédéterminé.

50. Ensemble de supports conforme à l'une quelconque des revendications 47 à 49, caractérisé en ce que des supports comprennent chacun des moyens pour inhiber (8) conformes à la revendication 45 ou 46 respectivement.

## Patentansprüche

1. Halterung für Gehäuse für eine integrierte Schaltung, umfassend unter der Halterung (1) liegende leitfähige Stifte ($10_1$ bis $10_{28}$), in denen leitfähige Stifte ($20_1$ bis $20_{28}$) des Gehäuses (2) stecken, dadurch gekennzeichnet, dass sie eine Aufnahme ($14_1$ und/oder $14_2$) zur Aufnahme einer beweglichen Hilfsversorgungsquelle ($4_1$ - $4_2$) umfasst, um eine Verbindung zwischen zwei vorbestimmten Stiften ($10_1$, $10_{15}$) der Halterung (1) vorzusehen, in denen Versorgungsstifte ($20_1$, $20_{15}$) des Gehäuses für eine integrierte Schaltung (2) stecken.

2. Halterung nach Anspruch 1, dadurch gekennzeichnet, dass die Aufnahme ($14_1$ und/oder $14_2$) vorzugsweise zwischen zwei parallelen Reihen von Stiften ($10_1$ bis $10_{14}$, $10_{15}$ bis $10_{28}$) der Halterung (1) liegt.

3. Halterung nach Anspruch 1 oder 2, dadurch gekennzeichnet, dass die Hilfsversorgungsquelle ($4_1$ - $4_2$) aus mehreren in Reihe angeschlossenen elementaren Versorgungsquellen, wie Miniaturzellen oder -akkumulatoren vom Knopftyp ($4_1$, $4_2$), zusammengesetzt ist.

4. Halterung nach Anspruch 3, dadurch gekennzeichnet, dass die elementaren Versorgungsquellen auf zumindest zwei verbundene Batterien ($4_1$, $4_2$) verteilt sind, die jeweils erste und zweite übereinanderliegende Stifte besitzen, und dass die Halterung (1; 1a; 1b) zwei Verbindungsleiter ($15_+$, $15_-$; $15a_-$; $15b_+$, $15b_-$), die jeweils mit den vorbestimmten Stiften ($10_1$, $10_{15}$; $10_1$, $10_8$) verbundene esrte Enden und zweite Enden, vorzugsweise in Form eines flexiblen Leiterplättchens, besitzen, die jeweils gegen erste Stifte mit entgegengesetzten Polaritäten ($40_1^+$, $40_2^-$) von zwei Batterien ($4_1$, $4_2$) plattiert sind, die Stifte der Hilfsversorgungsquelle ($4_1$ - $4_2$) bilden, und zumindest einen dritten Verbindungsleiter (5; 5a, 5b) umfasst, dessen Enden ($52_1$, $52_2$) gegen die zweiten Stifte mit entgegengesetzten Polaritäten ($40_1^-$, $40_2^+$) von zwei Batterien ($4_1$, $4_2$) plattiert sind.

5. Halterung nach Anspruch 4, dadurch gekennzeichnet, dass der dritte Verbindungsleiter (5) ein bewegliches Leiterelement der Halterung (1) ist.

6. Halterung nach Anspruch 4, dadurch gekennzeichnet, dass die zweiten Enden der beiden Verbinddungsleiter ($15_+$, $15_-$; 63) bewegliche Leiterelemente der Halterung (1; 1a) sind.

7. Halterung nach einem beliebigen der Ansprüche 1 bis 3, dadurch gekennzeichnet, dass die Halterung (1) zwei Verbindungsleiter ($15_+$; $52_1$, $15_G$) umfasst, die erste Enden, die jeweils mit den vorbestimmten Stiften ($10_1$, $10_{15}$) verbunden sind, und zweite Enden, vorzugsweise in der Form eines flexiblen Leiterplättchen, besitzen, die jeweils gegen Stifte ($40_1^+$, $40_2^-$) der Hilfsversorgungsquelle ($4_1$ - $4_2$) plattiert sind.

8. Halterung nach einem beliebigen der Ansprüche 4 bis 7, dadurch gekennzeichnet, dass die ersten Enden der beiden Verbindungsleiter ($15_+$, $15_-$; $15_+$, $52_1$, $15_G$) in der Halterung (1) eingebettet sind.

9. Halterung nach Anspruch 7 oder 8, dadurch gekennzeichnet, dass das eine der zweiten Enden der beiden Verbindungsleiter (63, Fig. 7; $52_1$, Fig. 18) ein bewegliches Leiterelement der Halterung (1) ist.

10. Halterung nach einem beliebigen der Ansprüche 5, 6 und 9, dadurch gekennzeichnet, dass das bewegliche Leiterelement (5; $52_1$) in die Halterung (1) einsteckbar ist.

11. Halterung nach einem beliebigen der Ansprüche 5, 6, 9 oder 10, dadurch gekennzeichnet, dass das bewegliche Leiterelement (5; $52_1$) in dem Gehäuse für eine integrierte Schaltung (2), vorzugsweise durch Kleben, befestigt ist.

12. Halterung nach einem beliebigen der Ansprüche 5, 6 oder 9, dadurch gekennzeichnet, dass das bewegliche Leiterelement (63) gegen eine Innenfläche eines Deckels ($6_2$) festsitzt, der die gesamte Aufnahme ($14_1$ und/oder $14_2$) oder einen Teil der Aufnahme, die die Hilfsversorgungsquelle ($4_1$ - $4_2$) enthält, der Halterung (1a) verschliesst.

13. Halterung nach Anspruch 12, dadurch gekennzeichnet, dass der Deckel ($6_2$) an der Halterung (1a) durch einen Bajonettverschluss (61, 62, 141, 142, 143, 144) befestigt ist.

14. Halterung nach einem beliebigen der Ansprüche 1 bis 13, dadurch gekennzeichnet, dass Stifte ($40_1^+$, $40_2^-$) der Hilfsversorgungsquelle ($4_1^-$, $4_2$; Fig. 1, 7, 10) parallel zu grossen Flächen des Gehäuses für eine integrierte Schaltung (2) und grossen Flächen der Halterung (1, 1a) sind.

15. Halterung nach einem beliebigen der Ansprüche 1 bis 10 und 12, dadurch gekennzeichnet, dass Stifte ($40_1^+$, $40_2^-$) der Hilfsversorgungsquelle ($4_1$ - $4_2$; Fig. 8, 9) senkrecht zu grossen Flächen des Gehäuses für eine integrierte Schaltung und zu grossen Flächen der Halterung (1b) sind.

16. Halterung nach Anspruch 15, dadurch gekennzeichnet, dass sie mit einem Deckel (6b) verbunden ist, der beweglich oder an der Halterung (1b) gelenkig angebracht ist und einen Hohlraum (14b) verschliesst, der die Hilfsversorgungsquelle ($4_1$ - $4_2$) enthält.

17. Halterung nach einem beliebigen der Ansprüche 1 bis 3, dadurch gekennzeichnet, dass sie mit einem beweglichen Deckel (9) der Halterung (1c) verbunden ist, der zwischen dem Gehäuse für eine integrierte Schaltung (2c) und der Halterung (1c) angeordnet ist und zumindest teilweise die Hilfsversorgungsquelle ($4_1$ - $4_3$ - $4_2$) überdeckt, wobei der Deckel Löcher ($91_1$ bis $91_{40}$) zur Aufnahme der Mittel ($11c_1$ bis $11c_{40}$) besitzt, um die Stifte ($20c_1$ bis $20c_{40}$) des Gehäuses für eine integrierte Schaltung (2c) mit den Stiften ($10c_1$ bis $10c_{40}$) der Halterung (1c) zu verbinden.

18. Halterung nach Anspruch 17, dadurch gekennzeichnet, dass die Mittel in jedem Loch ($91_1$ bis $91_{40}$) zum Verbinden eines Stifts ($20c_1$ bis $20c_{40}$) des Gehäuses für eine integrierte Schaltung mit einem Stift ($10c_1$ bis $10c_{20}$) der Halterung (1c) zwei flexible Leiterplättchen ($11c_1$ bis $11c_{40}$) umfassen, die an dem Stift ($10c_1$ bis $10c_{40}$) der Halterung (1c) befestigt sind und verschiebbar durch ein erstes Ende des Lochs dringen, wobei der Stift ($20c_1$ bis $20c_{40}$) des Gehäuses für eine integrierte Schaltung (2c) durch ein zweites Ende des Lochs und zwischen die beiden flexiblen Plättchen ($11c_1$ bis $11c_{40}$) dringt.

19. Halterung nach Anspruch 17 oder 18, gekennzeichnet durch Mittel ($98_1$, $98_2$, $131_1$, $131_2$) zum Verriegeln des Deckels (9) an der Halterung (1c).

20. Halterung nach Anspruch 19, dadurch gekennzeichnet, dass die Mittel zum Verriegeln ($98_1$, $98_2$, $131_1$, $131_2$) in gleicher Weise zum Einklemmen der Stifte ($20c_1$ bis $20c_{40}$) des Gehäuses der integrierten Schaltung (2c) in den Mitteln zum Verbinden ($11c_1$ bis $11c_{20}$) dienen, nachdem der Deckel mit der Halterung (1c) verriegelt worden ist.

21. Halterung nach Anspruch 17 oder 18, gekennzeichnet durch erste Mittel ($982_1$, $982_2$, $131_1$, $131_2$) zum Verriegeln des Deckels (9) an der Halterung (1c) in Folge auf einen ersten auf den Deckel zur Halterung hin ausgeübten Druck zum Halten der Hilfsversorgungsquelle ($4_1$ - $4_3$ - $4_2$) in der Halterung und durch zweite Mittel ($981_1$, $981_2$, $131_1$, $131_2$) zum Einklemmen der Stifte ($20c_1$ bis $20c_{40}$) des Gehäuses (2c) in den Mitteln zum Verbinden ($11c_1$ bis $11c_{20}$) in Folge auf einen zweiten auf das Gehäuse zum an der Halterung verriegelten Deckel hin ausgeübten Druck.

22. Halterung nach einem beliebigen der Ansprüche 19 bis 21, dadurch gekennzeichnet, dass die Mittel zum Verriegeln zumindest einen flexiblen Lappen ($98_1$) umfassen, der fest mit einer flexiblen konvexen Querleiste ($93_1$) des Deckels (9) verbunden ist und mit einer Rippe ($982_1$) versehen ist, wobei die Querleiste eine zum Stossen durch das Gehäuse für eine integrierte Schaltung (2c) geeignete Spitze besitzt und an zwei Längsträgern ($92_1$, $92_2$) des Deckels (9) befestigt ist, wobei die Längsträger mit den Löchern ($91_1$ bis $91_{40}$) versehen sind und gegen die Halterung (1c) angesetzt sind, und dass die Mittel zum Verriegeln in gleicher Weise eine in der Halterung (1c) gemachte Öffnung ($131_1$) zum Aufnehmen der Rippe ($982_1$) des Lappens ($98_1$) umfassen, um den Deckel (9) an der Halterung (1c) in Folge auf einen ersten auf den Deckel in Richtung der Halterung ausgeübten Druck zu verriegeln, wobei ein zweiter auf das Gehäuse (2c) in Richtung des an der Halterung (1c) verriegelten Deckels (9) ausgeübter Druck die Rippe ($982_1$) aus der Öffnung ($131_1$) auslöst, und die Rippe ($982_1$) unter der Querleiste ($93_1$) durchführt, um die Stifte ($20c_1$ bis $20c_{40}$) des Gehäuses für eine integrierte Schaltung (2c) in den Mitteln zum Verbinden ($11c_1$ bis $11c_{40}$) infolge einer Verringerung der Wölbung der Spitze der Querleiste ($91_1$) des Deckels (9) und eines merklichen Abstands der Längsträger ($92_1$, $92_2$) einzuklemmen.

23. Halterung nach einem beliebigen der Ansprüche 19 oder 21, dadurch gekennzeichnet, dass die Mittel zum Verriegeln (99, 132) derart sind, dass ein erster auf den Deckel (9) ausgeübter Druck zu einer Verriegelung des Deckels an der Halterung (1c) führt, ein zweiter auf das Gehäuse für eine integrierte Schaltung (2c) ausgeübter Druck zu einem Einklemmen der Stifte ($20c_1$ bis $20c_{40}$) des Gehäuses für eine integrierte Schaltung (2c) in den Mitteln zum Verbinden ($11c_1$ bis $11c_{40}$) führt und ein dritter auf das Gehäuse für eine integrierte Schaltung (2c) ausgeübter Druck zu einer Auslösung der Stifte ($20c_1$ bis $20c_{40}$) des Gehäuses von den Mitteln zum Verbinden ($11c_1$ bis $11c_{40}$) führt, ohne den Deckel (9) von der Halterung (1) zu entriegeln.

24. Halterung nach Anspruch 23, dadurch gekennzeichnet, dass die Mittel zum Verriegeln (99, 132) zumindest einen flexiblen Lappen (99) umfassen, der mit einer flexiblen Querleiste ($98_1$) des vorzugsweise geschlitzten (990) Deckels verbunden ist, der ein durch einen Kragen (992) erhöhtes Ende (999) besitzt, wobei die Querleiste eine zum Stossen durch das Gehäuse für eine integrierte Schaltung (2c) geeignete Spitze besitzt und an zwei Längsträgern ($92_1$, $92_2$) des Deckels befestigt ist, wobei die Längsträger mit den Löchern ($91_1$ bis $91_{40}$) versehen sind und gegen die Halterung (1c) gelegt sind, und dass die Mittel zum Verriegeln in gleicher Weise zwei Löcher (132) in der Halterung (1c) umfassen, wobei jedes Loch ein Ende unter dem Lappen (99) des Deckels (9), das einen festen Ring (133) mit Nut (134) enthält, und eine Kammer (136) besitzt, die eine freigewegliche Unterlegscheibe (137) enthält, wobei der erste Druck den Kragen (992) in die Nut (134) einführt, wobei der zweite Druck das Ende des Lappens (999) in die Kammer (136) und den Kragen (992) unter den Ring (133) einführt und wobei der dritte Druck das Ende des Lappens (999) in die Unterlegscheiben (137) und das Ergreifen dieser durch den Kragen (992) einführt, wobei dann der Lappen (99) in der Kammer (136) steigt, wobei er die gegen den Ring (133) anstossende Unterlegscheibe (137) freigibt und im Ring (133) durch die Einführung des Kragens (992) in die Nut (134) infolge der gegen das Gehäuse (2c) gerichteten Eigenelastizität der Querleiste ($98_1$, $98_2$) des Deckels (8) angehalten wird.

25. Halterung nach einem beliebigen der Ansprüche 1 bis 3 und 17 bis 24, dadurch gekennzeichnet, dass sie mit einem beweglichen Deckel (9) der Halterung (1c) verbunden ist, der zwischen dem Gehäuse für eine integrierte Schaltung (2c) und der Halterung (1c) angeordnet ist und zumindest teilweise die Hilfsversorgungsquelle ($4_1$) überdeckt, wobei der Deckel (9) einen Leiter ($138_1$) umfasst, der ein erstes Ende ($139_1$) besitzt, das unter dem Deckel (9) herauskommt und zwischen einem Abschnitt ($111_1$) eines der vorbestimmten Stifte ($10c_1$) der Halterung (1c) anwendbar ist, und ein zweites Ende ($95_+$), vorzugsweise in Form eines flexiblen Leiterplättchens, besitzt, das gegen einen der Anschlüsse ($40_i^+$) der Hilfsversorgungsquelle anwendbar ist, wobei die Halterung (1c) einen Leiter ($5c_1$) umfasst, der ein erstes mit dem anderen vorbestimmten Stift ($10c_{21}$) der Halterung (1c) verbundenes Ende besitzt und ein zweites Ende, vorzugsweise in Form eines flexiblen Leiterplättchens, besitzt, das gegen den anderen Anschluss ($40_i^-$) der Hilfsversorgungsquelle legbar ist.

26. Halterung nach einem beliebigen der Ansprüche 1, 2 und 17 bis 24, dadurch gekennzeichnet, dass sie mit einem beweglichen Deckel (9) der Halterung (1c) verbunden ist, der zwischen dem Gehäuse für eine integrierte Schaltung (2c) und der Halterung (1c) angeordnet ist und zumindest teilweise die Hilfsversorgungsquelle ($4_1$ - $4_3$ - $4_2$) überdeckt, wobei der Deckel (9) zwei Leiter ($138_1$, $138_2$) umfasst, die jeweils ein erstes Ende und ein zweites Ende besitzen, wobei die ersten Enden ($139_1$, $139_2$) der Leiter unter dem Deckel (9) herauskommen und jeweils gegen Abschnitte ($111_1$, $111_{21}$) der vorbestimmten Stifte ($10c_1$, $10c_{21}$) der Halterung (1c) legbar sind und die zweiten Enden ($95_+$, $95_-$) der Leiter, vorzugsweise in Form eines flexiblen Leiterplättchens,

gegen Anschlüsse ($40_1^+$, $40_2^-$) der Hilfsversorgungsquelle ($4_1$ - $4_3$ - $4_2$) legbar sind.

27. Halterung nach Anspruch 26, dadurch gekennzeichnet, dass die Hilfsversorgungsquelle ($4_1$ - $4_3$ - $4_2$) zumindest zwei verbundene Batterien ($4_1$, $4_2$) umfasst und dabei jeweils eine oder mehrere übereinanderliegende elementare Versorgungsquellen wie Miniaturzellen oder -akkumulatoren umfasst, wobei die Halterung (1c) oder der Deckels (9) zumindest einen Verbindugsleiter ($5c_1$, $5c_2$), vorzugsweise in Form eines flexiblen Leiterplättchens, besitzen, um zwei benachbarte verbundene Batterien ($4_1$, $4_3$; $4_3$, $4_2$) in Reihe zu verbinden.

28. Halterung nach einem beliebigen der Ansprüche 1 bis 27, dadurch gekennzeichnet, dass sie Mittel (56) zum Trennen der Hilfsversorgungsquelle ($4_1$ - $4_3$ - $4_2$) von den vorbestimmten Stiften ($20c_1$, $20c_2$) der Halterung (1c) ohne Herausziehen eines beliebigen Elements der Halterung (1c) umfasst.

29. Halterung nach Anspruch 28, dadurch gekennzeichnet, dass die Hilfsversorgungsquelle ($4_1$ - $4_3$ - $4_2$) zumindest eine elementare Versorgungsquelle ($4_2$) wie z.B. einen Zellenknopf umfasst, der einen diskusförmigen Anschluss ($40_2^+$) besitzt, und dass die Mittel zum Trennen ein zylindrisches, elektrisch isolierendes Element (56) umfassen, das den diskusförmigen Anschluss ($40_2^+$) einschliessende periphere Segmente (57) und einen Hebel (58) besitzt, wobei der Hebel in einer ersten Position (59S), in der ein mit einem der vorbestimmten Stifte ($10c_1$) verbundener flexibler Leiter ($5c_2$) gegen den diskusförmigen Anschluss ($40_2^+$) plattiert ist und infolge einer Drehung des isolierenden Elements (56) in der Halterung (1c) in einer zweiten Position (59H) ist, in der der flexible Leiter ($5c_2$) gegen eines der Segmente (57) plattiert ist, um den diskusförmigen Anschluss ($40_2^+$) von dem vorbestimmten Stift ($10c_1$) zu trennen.

30. Halterung nach einem beliebigen der Ansprüche 1 bis 29, dadurch gekennzeichnet, dass die Hilfsversorgungsquelle mehrere verbundene Batterien von in Reihe verbundenen elementaren Quellen, wie Zellen oder Akkumulatoren vom Knopftyp ($4_1$, $4_2$, $4_3$), umfasst, und dass die Halterung (1, 1c) mehrere getrennte Aufnahmen ($14c_1$, $14c_2$, $14c_3$) wie Langlöcher oder Hohlräume mit Boden, umfasst, um jeweils die Batterien ($4_1$, $4_2$, $4_3$) aufzunehmen, wobei die Aufnahmen einen vorzugsweise zu demjenigen der Batterien analogen Querschnitt besitzen.

31. Halterung nach den Ansprüchen 29 und 30, dadurch gekennzeichnet, dass das zylindrische isolierende Element (56) drehbar in einer der Aufnahmen ($14c_2$) angebracht ist und dass der Hebel (58) flexibel ist, sich in zwei Nuten (59S, 59M) der Halterung jeweils für die beiden Positionen einfügt und aus der Halterung (1c) vorsteht.

32. Halterung nach einem beliebigen der Ansprüche 1 bis 31, dadurch gekennzeichnet, dass sie ein unter der Halterung (1) liegendes und durch die Stifte ($10_1$ bis $10_{28}$) der Halterung (1) durchquertes isolierendes Blatt (54) umfasst.

33. Halterung nach einem beliebigen der Ansprüche 1 bis 32, dadurch gekennzeichnet, dass sie eine Diode ($D_1$) umfasst, die vorzugsweise in die Halterung (1) oder in den Deckel (9) eingebettet ist, wobei sie zumindest teilweise die Halterung (1c) überdeckt, die zwischen einem der vorbestimmten Stifte ($10_1$) der Halterung und einem Anschluss ($40_1^+$) der Hilfsversorgungsquelle ($4_1$ - $4_2$) angeordnet ist.

34. Halterung nach Anspruch 33, dadurch gekennzeichnet, dass sie einen unterhalb der Halterung (1) liegenden zusätzlichen Stift ($10_T$) oder ein Leiterkniestück (91T) umfasst, das vom Deckel (9) vorspringt, der mit dem Anschluss ($40_1^+$) der Hilfsversorgungsquelle ($4_1$ - $4_2$) und mit der Diode ($D_1$) verbunden ist.

35. Halterung nach einem beliebigen der Ansprüche 1 bis 34, dadurch gekennzeichnet, dass sie zwei Leiterbahnen ($16_+$, $16_-$), vorzugsweise auf zwei parallelen Schmalseiten der Halterung (1), und zwei Verbindungsleiterelemente ($17_+$, $17_-$) umfasst, die jeweils ein an einem der vorbestimmten Stifte ($10_1$, $10_{15}$) befestigtes Ende und ein Ende besitzen, das vorzugsweise durch Löten an einer der Leiterbahnen ($16_+$, $16_-$) befestigbar ist.

36. Konstruktion von Halterungen, die jeweils ein Gehäuse für eine integrierte Schaltung tragen, gemäss Anspruch 35, dadurch gekennzeichnet, dass lediglich eine Halterung (1A) eine Hilfsversorgungsquelle ($4_1$ - $4_2$) umfasst und ihre Leiterbahnen ($16_+$, $16_-$) jeweils mit den Leiterbahnen der anderen Halterungen (1B, 1C) durch Steckverbindungen ($ST_+$, $ST_-$) verbunden sind.

37. Halterung nach einem beliebigen der Ansprüche 1 bis 35, dadurch gekennzeichnet, dass sie Überwachungsmittel (7) umfasst, um eine Spannung an den Anschlüssen ($40_1^+$, $40_2^-$) der Hilfsversorgungsquelle ($4_1$ - $4_2$) unterhalb einer vorbestimmten Entladungsschwelle zu detektieren.

38. Halterung nach Anspruch 37, dadurch gekennzeichnet, dass die Überwachungsmittel (7) in Hybrid- oder integrierter Form sind, in einem vorzugsweise beweglichen Gehäuse (75-76) der Halterung (1) liegen und besonders mit Zusatzstiften ($10_S$, $10_V$, $10_P$, $10_{RZ}$) der Halterung verbunden sind.

39. Halterung nach Anspruch 37 oder 38, dadurch gekennzeichnet, dass die Überwachungsmittel einen Oszillator (70), vorzugsweise mit Hörfrequenz, der durch die Spannung an den Anschlüssen ($40_1^+$, BT; $40_2^-$, BG) der Hilfsversorgungsquelle ($4_1$ - $4_2$) gesteuert ist, und Signalgebungsmittel (72) umfassen, die durch ein Signal (705) erregt werden, das vom Oszillator (70) ansprechend auf die Freigabe des Oszillators (70) durch eine Spannung an den Anschlüssen der Hilfsversorgungsquelle unterhalb der vorbestimmten Schwelle ausgeht.

40. Halterung nach Anspruch 39, dadurch gekennzeichnet, dass die Frequenz des vom Oszillator (70) ausgehenden Signals zur Spannung an den Anschlüssen ($40_1^+$, BT; $40_2^-$, BG) der Hilfsversorgungsquelle ($4_1$ - $4_2$) umgekehrt proportional ist.

41. Halterung nach Anspruch 39 oder 40, dadurch gekennzeichnet, dass die Signalgebungsmittel (72) eine Anzeigevorrichtung (725) wie lichtemittierende Dioden oder eine Leiste mit Flüssigkristallen umfassen.

42. Halterung nach einem beliebigen der Ansprüche 39 bis 41, dadurch gekennzeichnet, dass die Signalgebungsmittel (72) einen elektroakustischen Wandler (721), vorzugsweise wie ein piezoelektrischer Miniatur-Schnarrsummer, umfassen.

43. Halterung nach Anspruch 42, dadurch gekennzeichnet, dass der elektroakustische Wandler (721) am Gehäuse für eine integrierte Schaltung (2) befestigbar ist.

44. Halterung nach einem beliebigen der Ansprüche 39 bis 43, dadurch gekennzeichnet, dass die Überwachungsmittel (7) Mittel (71) zum periodischen Auslösen des Oszillators (70) umfassen.

45. Halterung nach einem beliebigen der Ansprüche 1 bis 44, dadurch gekennzeichnet, dass sie Mittel (8) zum Verhindern einer vorbestimmten Funktion der integrierten Schaltung (2) umfasst, wenn die Spannung einer Hauptversorgungsquelle (AP) zwischen den Versorgungsstiften ($20_1$; $20_{15}$, BG) verschwindet.

46. Halterung nach Anspruch 45, dadurch gekennzeichnet, dass die Mittel zum Verhindern (8) einen ersten Transistor (80), der eine mit dem positiven Anschluss ($AP_+$) der Hauptversorgungsquelle (AP), vorzugsweise über einen Widerstand (84) verbundene Basis besitzt, und einen zweiten Transistor (81) umfassen, der eine mit dem Kollektor des ersten Transistors (80) verbundene Basis und einen vorzugsweise über eine Diode (85) mit einem Verhinderungsanschluss (87) der integrierten Schaltung (2) verbundenen Kollektor besitzt, wobei die Kollektoren der Transistoren (80, 81) jeweils mit den positiven Anschlüssen der Hauptversorgungsquelle (AP) und mit der Hilfsquelle ($4_1$ - $4_2$) vorzugsweise über einen Widerstand (82, 83) und Dioden ($D_2$, $D_1$) verbunden sind.

47. Konstruktion von jeweils ein Gehäuse für eine integrierte Schaltung tragenden Halterungen, die auf einer Leiterplatte (3) angebracht sind, dadurch gekennzeichnet, dass die Halterungen ($1_1$ bis $1_6$, $7_1$ bis $7_6$) gemäss Anspruch 41 sind und dass eine der Halterungen ($1_1$, $7_1$) gemäss Anspruch 42 oder 43 ist, wobei der elektroakustische Wandler (721) mit den Ausgängen ($705_1$ bis $705_6$) der Oszillatoren ($70_1$ bis $70_6$) verbunden ist, die durch sämtliche Halterungen über logische Tore ($729_1$ bis $729_6$) gehalten sind.

48. Konstruktion von jeweils ein Gehäuse für eine integrierte Schaltung tragenden Halterungen , die auf einer Leiterplatte (3) angeordnet sind, dadurch gekennzeichnet, dass die Halterungen ($1_1$ bis $1_6$) gemäss einem der Ansprüche 1 bis 36 sind und dass eine der Halterungen ($1_1$, $7_1$) gemäss Anspruch 42 oder 43 ist, wobei die durch die Halterung gemäss Anspruch 42 oder 43 getragenen Überwachungsmittel (7) mit der Hilfsversorgungsquelle ($AS_1$ bis $AS_6$) jeder der Halterungen verbunden einen Oszillator ($70_1$ bis $70_6$) und Signalgebungsmittel ($725_1$ bis $726_6$) gemäss einem der Ansprüche 39 bis 41 umfassen.

49. Konstruktion von Halterungen gemäss Anspruch 47 oder 48, dadurch gekennzeichnet, dass eine der Halterungen ($1_1$, $7_1$) Mittel (71) zum periodischen Auslösen der Oszillatoren ($70_1$ bis $70_6$) und Mittel (714, 715) umfasst, um eines der von den Oszillatoren ($70_1$ bis $70_6$) ausgehenden Signale auszugeben, wenn die Spannung an den Anschlüssen der entsprechenden Hilfsversorgungsquelle ($AS_1$ bis $AS_6$) unterhalb einer vorbestimmten Entladungsschwelle ist.

50. Konstruktion von Halterungen gemäss einem beliebigen der Ansprüche 47 bis 49, dadurch gekennzeichnet, dass die Halterungen jeweils Mittel zum Verhindern (8) gemäss Anspruch 45 bzw. 46 umfassen.

**Claims**

1. Integrated circuit package holder comprising, subjacent to the holder (1), conductive pins ($10_1$ to $10_{28}$) in which conductive pins ($20_1$ to $20_{28}$) of the package (2) are plugged, characterized in that it comprises a recess ($14_1$ and/or $14_2$) for receiving a removable spare power source ($4_1$ - $4_2$) to be interconnected between two predetermined pins, ($10_1$, $10_{15}$) of the holder (1) in which are plugged supply pins ($20_1$, $20_{15}$) of the integrated package (2).

2. Holder according to claim 1, characterized in that the recess ($14_1$ and/or $14_2$) is located preferably between two parallel rows of pins ($10_1$ to $10_{14}$, $10_{15}$ to $10_{28}$) of the holder (1).

3. Holder according to claim 1 or 2, characterized in that the spare power source ($4_1$ - $4_2$) is composed of several elementary power sources connected in series such as button type miniature cells or accumulators ($4_1$, $4_2$).

4. Holder according to claim 3, characterized in that the elementary power sources are at least divided into zwo juxtaposed power batteries ($4_1$, $4_2$) each having first and second superposed terminals, and in that the holder (1; 1a; 1b) comprises two connecting conductors ($15_+$, $15_-$; $15a_-$; $15b_+$, $15b_-$) having first ends respectively connected to the predetermined pins ($10_1$, $10_{15}$; $10_1$, $10_8$), and second ends, preferably forming resilient conductive reeds, respectively applied against first opposite polarity terminals ($40_1^+$, $40_2^-$) of the two batteries ($4_1$, $4_2$) forming terminals of the spare power source ($4_1$ - $4_2$), and at least a third connecting conductor (5; 5a, 5b) having ends ($52_1$, $52_2$) applied against second opposite polarity terminals ($40_1^-$, $40_2^+$) of the two batteries ($4_1$, $4_2$).

5. Holder according to claim 4, characterized in that the third connecting conductor (5) is a conductive member removable from the holder (1).

6. Holder according to claim 4, characterized in that the second ends of said two connecting conductors ($15_+$, $15_-$; 63) are conductive members removable from the holder (1; 1a).

7. Holder according to any one of claims 1 to 3, characterized in that the holder (1) comprises two connecting conductors ($15_+$; $52_1$, $15_G$) having first ends connected respectively to the predetermined pins ($10_1$, $10_{15}$), and second ends, preferably forming resilient conductive reeds, applied respectively against terminals ($40_1^+$, $40_2^-$) of the spare power source ($4_1$ - $4_2$).

8. Holder according to any one of claims 4 to 7, characterized in that the first ends of said two connecting conductors ($15_+$, $15_-$; $15_+$, $52_1$, $15_G$) are embedded within the holder (1).

9. Holder according to claim 7 or 8, characterized in that one of the second ends of said two connecting conductors (63, Fig. 7; $52_1$, Fig. 18) is a conductive member removable from the holder (1).

10. Holder according to any one of claims 5, 6 and 9, characterized in that said removable conductive member $(5; 52_1)$ is pluggable in the holder (1).

11. Holder according to any one of claims 5, 6, 9 or 10, characterized in that said removable conductive member $(5; 52_1)$ is secured beneath the integrated circuit package (2), preferably by sticking.

12. Holder according to any one of claims 5, 6 or 9, characterized in that said removable conductive member (63) is secured against an internal side of a cover $(6_2)$ closing off all or part of the recess $(14_1$ and/or $14_2)$ of the holder (1a) including the spare power source $(4_1 - 4_2)$.

13. Holder according to claim 12, characterized in that the cover $(6_2)$ is secured to the holder (1a) by a bayonet fastening (61, 62, 141, 142, 143, 144).

14. Holder according to any one of claims 1 to 13, characterized in that terminals $(40_1^+, 40_2^-)$ of the spare power source $(4_1, 4_2;$ Figs. 1, 7, 10) are parallel to major sides of the integrated circuit package (2) and to major sides of the holder (1, 1a).

15. Holder according to any one of claims 1 to 10 and 12, characterized in that terminals $(40_1^+, 40_2^-)$ of the spare power source $(4_1 - 4_2;$ Fig. 8, 9) are perpendicular to major sides of the integrated circuit package and to major sides of the holder (1b).

16. Holder according to claim 15, characterized in that it is associated with a cover (6b) removable or articulated with respect to the holder (1b) and closing off a recess (14b) in which is included the spare power source $(4_1 - 4_2)$.

17. Holder according to any one of claims 1 to 3, characterized in that it is associated with a cover (9) removable from the holder (1c), inserted between the integrated circuit package (2c) and the holder (1c) and at least partly covering the spare power source $(4_1 - 4_3 - 4_2)$, said cover having holes $(91_1$ to $91_{40})$ for receiving means $(11c_1$ to $11c_{40})$ for connecting the pins $(20c_1$ to $20c_{40})$ of the integrated circuit package (2c) to the pins $(10c_1$ to $10c_{40})$ of the holder (1c).

18. Holder according to claim 17, characterized in that in each hole $(91_1$ to $91_{40})$, the means for connecting a pin $(20c_1$ to $20c_{40})$ of the integrated circuit package to a pin $(10c_1$ to $10c_{20})$ of the holder (1c) comprises two resilient conductive reeds $(11c_1$ to $10c_{40})$ secured to the pin $(10c_1$ to $10c_{20})$ of the holder (1c) and slidably entering through a first end of the hole, the pin $(20c_1$ to $20c_{40})$ of the integrated circuit package (2c) entering through a second end of the hole and between said two resilient reeds $(11c_1$ to $11c_{40})$.

19. Holder according to claim 17 or 18, characterized by means $(98_1, 98_2, 131_1, 131_2)$ for locking the cover (9) to the holder (1c).

20. Holder according to claim 19, characterized in that the locking means $(98_1, 98_2, 131_1, 132_2)$ serves in pinching the pins $(20c_1$ to $20c_{40})$ of the integrated circuit package (2c) into the connecting means $(11c_1$ to $11c_{20})$ after locking the cover to the holder (1c).

21. Holder according to claim 17 or 18, characterized by first means $(982_1, 982_2, 131_1, 131_2)$ for locking the cover (9) to the holder (1c) in response to a first pressure exerted onto the cover towards the holder in order to fixedly hold the spare power source $(4_1 - 4_3 - 4_2)$ in the holder, and by second means $(981_1, 981_2, 131_1, 131_2)$ for pinching the pins $(20c_1$ to $20c_{40})$ of the package (2c) into the connecting means $(11c_1$ to $11c_{20})$ in response to a second pressure exerted on the package toward the cover locked to the holder.

22. Holder according to any one of claims 19 to 21, characterized in that the locking means comprises at least a resilient lug $(98_1)$ jointed to a convex resilient cross-member $(93_1)$ of the cover (9) and having a rib $(982_1)$, said cross-member having a top designed to be pushed by the integrated circuit package (2c) and being secured to two side-members $(92_1, 92_2)$ of the cover (9), the side-members being provided with said holes $(91_1$ to $91_{40})$ and being applied against the holder (1c), and in that the locking means also comprises an aperture $(131_1)$ made in the holder (1c) for receiving the rib $(982_1)$ of the lug $(98_1)$ in order to lock the cover (9) to the holder (1c) after a first pressure exerted onto the cover in the direction of the holder, a second pressure exerted onto the package (2c) in the direction of the cover (9) locked to the holder (1c) for releasing the rib $(982_1)$ from the aperture $(131_1)$ and pushing the rib $(982_1)$ beneath said cross-member $(93_1)$ in order to pinch the pins $(20c_1$ to $20c_{40})$ of the integrated circuit package (2c) into the connecting means $(11c_1$ to $11c_{40})$, as a result of the convexity diminution of the top of the cross-member (91) of the cover (9) and a substantial increasing distance between the side-members $(92_1, 92_2)$.

23. Holder according to any one of claims 19 to 21, characterized in that the locking means (99, 132) are designed in such a way that a first pressure exerted onto the cover (9) leads a locking of the cover to the holder (1c), a second pressure exerted onto the integrated circuit package (2c) leads a pinch of the pins $(20c_1$ to $20c_{40})$ of the integrated circuit package (2c) into the connecting means $(11c_1$ to $11c_{40})$, and a third pressure exerted onto the integrated circuit package (2) leads a release of the holder pins $(20c_1$ to $20c_{40})$ from the connecting means $(11c_1$ to $20c_{40}$ ) without unlocking the cover (9) from the holder (1).

24. Holder according to claim 23, characterized in that the locking means (99, 132) comprises at least a resilient lug (99) jointed to a resilient cross-member $(98_1)$ of the cover, preferably slit (990), having an end (999) topped by a flange (992), said cross-member having a top designed to be pushed by the integrated circuit package (2c) and being secured to two side-members $(91_1, 92_2)$ of the cover, the side-members, being provided with said holes $(91_1$ to $91_{40})$ and being applied against the holder (1c), and in that the locking means comprises two holes (132) in the holder (1c), each hole having an end beneath the lug (99) of the cover (9) including a fixed ring (133) provided with a groove (134) and a chamber (136) housing a freely moving washer (137), said first pressure inserting the flange (992) into the groove (134), said second pressure inserting the lug end (999) into the chamber (136) and the flange (992) beneath the ring (133), and said third pressure inserting the lug end (999) into the washers (137) which are catched by the flange (992), then the lug (99) moving back up the chamber (136), freeing the washer (137) butting against the ring (133), and being stopped in the ring (133) by the entrance of the flange (992) into the groove (134), as a result of the resilient action of the cross-member $(98_1, 98_2)$ of the cover (9) pointed towards the package (2c).

25. Holder according to any one of claims 1 to 3 and 17 to 24, characterized in that it is associated with a cover (9) removable from the holder (1c), inserted between the integrated circuit package (2c) and the holder (1c) and at least partly covering the spare power source $(4_1)$, said cover (9) comprising a conductor $(138_1)$ having a first end $(139_1)$ protuding beneath the cover (9) to be applied against a portion $(111_1)$ of one of the predetermined pins $(10c_1)$ of the holder (1c) and having a second end $(95_+)$, preferably forming a resilient conductive reed, to be applied against one of the spare power source terminals $(40_1^+)$, said holder (1c) comprising a conductor $(5c_1)$ having a first end connected to the other predetermined pin $(10c_{21})$ of the holder (1c) and having a second end, preferably forming a resilient conductive reed, to be applied against the other spare power source terminal $(40_1^-)$.

26. Holder according to any one of claims 1, 2 and 17 to 24, characterized in that it is associated with a cover (9) removable from the holder (1c), inserted between the integrated circuit package (2c) and the holder (1c) and at least partly covering the spare power source $(4_1 - 4_3 - 4_2)$, said cover (9) comprising two conductors $(138_1, 138_2)$ each having a first end and a second end, the first ends $(139_1, 139_2)$ of said conductors protruding beneath the cover (9) and being applied against portions $(111_1, 111_{21})$ of the predetermined pins $(10c_1, 10c_{21})$ of the holder (1c) respectively and the second ends $(95_+, 95_-)$ of said conductors, preferably forming resilient conductive reeds, being applied against terminals $(40_1^+, 40_2^-)$ of the spare power source $(4_1 - 4_3 - 4_2)$.

27. Holder according to claim 26, characterized in that the spare power source $(4_1 - 4_3 - 4_2)$ comprises at least two juxtaposed power batteries $(4_1, 4_2)$ each comprising one or several juxtaposed elementary power sources, such as miniature cells or batteries, said holder (1c) or said cover (9) comprising at least a connecting conductor $(5c_1, 5c_2)$, preferably forming a resilient conductive reed, for series-connecting two adjacent juxtaposed batteries $(4_1, 4_3; 4_3, 4_2)$.

28. Holder according to any one of claims 1 to 27, characterized in that it comprises means (56) for disconnecting the spare power source $(4_1 - 4_3 - 4_2)$ from predetermined pins $(20c_1, 20c_2)$ of the holder (1c) without removing any member of the holder (1c).

29. Holder according to claim 28, characterized in that the spare power source $(4_1 - 4_3 - 4_2)$ comprises at least an elementary power source $(4_2)$, such as a button cell, having a discoid terminal $(40_1^+)$, and in that the disconnecting means comprises an electrically insulating cylindrical member (56) having peripheric segments catching said discoid terminal $(40_2^+)$ and a lever (58), said lever being located at a first emplacement (59S) for which a

resilient conductor $(5c_2)$ connected to one of the predetermined pins $(10c_1)$ is applied against said discoid terminal $(40_2^+)$, and, after rotating said insulating member 56 in the holder (1c), at a second emplacement (59H) for which the resilient conductor $(5c_2)$ is applied against one of the segments (57) thereby disconnecting said discoid terminal $(40_2^+)$ from said predetermined pin $(10c_1)$.

30. Holder according to any one of claims 1 to 29, characterized in that said spare power source comprises several series-connected juxtaposed power batteries of elementary sources, such as cells or button-type accumulators $(4_1, 4_2, 4_3)$, and in that the holder $(1, 1c)$ comprises several separated recesses $(14c_1, 14c_2, 14c_3)$, such as slots or blind cavities, for receiving respectively the batteries $(4_1, 4_2, 4_3)$, said recesses having a section preferably analogous to the battery section.

31. Holder according to claims 29 to 30, characterized in that the insulating cylindrical member (56) is rotatably mounted in one of said recesses $(14c_2)$ and in that the lever (58) is resilient, is fittable into two grooves (59S, 59M) of the holder respectively for the two emplacements and extends beyond the holder (1c).

32. Holder according to any one of claims 1 to 31, characterized in that it comprises an insulating sheet (54), subjacent to the holder (1), through which the pins $(10_1$ to $10_{28})$ of the holder (1) run.

33. Holder according to any one of claims 1 to 32, characterized in that it comprises a diode $(D_1)$, preferably embedded in the holder (1) or a cover (9) at least partly covering the holder (1c), interconnected between one of the predetermined holder pins $(10_1)$ and a terminal $(40_1^+)$ of the spare power source $(4_1 - 4_2)$.

34. Holder according to claim 33, characterized in that it comprises an additional pin $(10_T)$ subjacent to the holder (1), or a conductive bend $(91_T)$ protruding from the cover (9) and connected to said terminal $(40_1)$ of the spare power source $(4_1 - 4_2)$ and to said diode $(D_1)$.

35. Holder according to any one of claims 1 to 34, characterized in that it comprises two conductives strips $(16_+, 16_-)$, preferably onto parallel edges of the holder (1), and two connecting conductive members $(17_+, 17_-)$ each having an end secured to one of the two predetermined pins $(10_1, 10_{15})$ and an end securable, preferably by soldering, to one of the conductive strips $(16_+, 16_-)$.

36. Assembly of holders for each holding an integrated circuit package, according to claim 35, characterized in that only one holder (1A) comprises a spare power source $(4_1 - 4_2)$ and has its conductive strips $(16_+, 16_-)$ respectively connected to the conductive strips of the other holders (1B, 1C) via straps $(ST_+, ST_-)$.

37. Holder according to any one of claims 1 to 35, characterized in that it comprises monitoring means (7) for detecting a voltage lower than a predetermined discharge threshold across the terminal $(40_1^+, 40c_2)$ of the spare power source $(4_1 - 4_2)$.

38. Holder according to claim 37, characterized in that the monitoring means (7) is in an hybrid or integrated form, is lodged in a package (75-76) preferably removable from the holder (1) and is connected particularly to additional holder pins ($10_S$, $10_V$, $10_p$, $10_{RZ}$).

39. Holder according to claim 37 or 38, characterized in that the monitoring means comprises an oscillator (70), preferably at an audio frequency, controlled by the voltage at the terminals ($40_1^+$, BT; $40_2^-$, BG) of the spare power source ($4_1$ - $4_2$), and signalling means (72) activated by a signal (705) outputting from the oscillator (70) in response to the oscillator (70) being triggered by a voltage across the spare power source terminals lower to the predetermined threshold.

40. Holder according to claim 39, characterized in that the frequency of the signal outputting from the oscillator (70) is inversely proportional to the voltage across the terminals ($40_1^+$, BT; $40_2^-$, BG) of the space power source ($4_1$ - $4_2$).

41. Holder according to claim 39 or 40, characterized in that the signalling means (72) comprises a display device (725), such as light emitting diodes or a liquid crystal block.

42. Holder according to any one of claims 39 to 41, characterized in that the signalling means comprises an electroacoustic transducer (721) preferably such as a miniature piezoelectric buzzer.

43. Holder according to claim 42, characterized in that the electroacoustic transducer (721) is fixable to the integrated circuit package (2).

44. Holder according to any one of claims 39 to 43, characterized in that the monitoring means (7) comprises means for periodically triggering the oscillator (70).

45. Holder according to any one of claims 1 to 44, characterized in that it comprises means (8) for inhibiting a predetermined function in the integrated circuit (2) when a main power source voltage (AP) across supply pins ($20_1$; $20_{15}$, BG) disappear.

46. Holder according to claim 45, characterized in that the inhibiting means (8) comprises a first transistor (80) having a base connected to a positive terminal ($AP_+$) of the main power source (AP) preferably through a resistor (84), and a second transistor (81) having a base connected to a collector of the first transistor (80) and having a collector connected to an inhibiting terminal (57) of the integrated circuit (2) preferably through a diode (85), collectors of the transistors (80, 81), each being connected to positive terminals of the main power source (AP) and spare power source ($4_1$ - $4_2$) preferably through a resistor (82, 83) and diodes ($D_2$, $D_1$).

47. Assembly of holders for each holding an integrated circuit package, arranged on a printed circuit board (3), characterized in that the holders ($1_1$ to $1_6$, $7_1$ to $7_6$) are in accordance with claim 41 and in that one of the holders ($1_1$, $7_1$) is in accordance with claim 42 or 43, said electroacoustic transducer (721) being connected to the outputs ($705_1$ to $705_6$) of the oscillators ($70_1$ to $70_6$) held by all the holders, through logical gates ($729_1$ to $729_6$).

48. Assembly of holders for each holding an integrated circuit package, arranged on a printed circuit board (3), characterized in that the holders ($1_1$ to $1_6$) are in accordance with one of claims 1 to 36 and in that one of the holders ($1_1$, $7_1$) is in accordance with claim 42 to 43, the monitoring means (7) held by said holder according to claim 42 or 43 comprising, associated to the spare power source ($AS_1$ to $AS_6$) of each holder, an oscillator ($70_1$ to $70_6$) and signalling means ($725_1$ to $726_6$) according to one of claims 39 to 41.

49. Assembly of holders according to claim 47 or 48, characterized in that one of the holders ($1_1$, $7_1$) comprises means (71) for periodically triggering the oscillators ($70_1$ to $70_6$) and means (714, 716) for delivering one of the signals outputting from the oscillators ($70_1$ to $70_6$) when the voltage across the terminals of the corresponding spare power source ($AS_1$ to $AS_6$) is lower than the predetermined discharge threshold.

50. Assembly of holders according to any one of claims 47 to 49, characterized in that holders comprise inhibiting means (8) according to claim 45 or 46, respectively.

FIG.1

# FIG.2

# FIG.6

# FIG.3

# FIG.4

# FIG.5

# FIG.7

# FIG.8

# FIG.9

FIG.10

# FIG 11

A

$+$ $-$

56 $5c_2$

B

$+$ $-$

$5c_1$ 56

C

$+$ $-$

56 $5c_2$

D

$+$ $-$

$5c_1$ 56

E

$95_+$  $13c_3$  $13c_4$  $95_-$

$+$ $-$

56  $5c_1$  $5c_2$

F

$95_+$  $40_1^+$  $13c_3$  $40_3^+$  $13c_4$  $40_2^-$  $95_-$

$+$  $4_3$  $4_2$

$4_1$  $58$

$40_1^-$  $5c_1$  $40_3^-$  $5c_2$  $40_2^+$  56

G

$95_+$  $13c_3$  $13c_4$  $95_-$

$+$ $-$

56  $5c_1$  $5c_2'$

H

$95_+$  $13c_3$  $13c_4$  $95_-$

$+$ $-$

$5c_1'$  $5c_2'$  56

FIG.12

FIG.15

**FIG.13**

**FIG.16**

**FIG.17**

# FIG.14

**FIG.18**

# FIG.19

70

702
704
701
703
705
706 BG
OSCILLATEUR

BG
BT
73
74

42
41

72
+ BP CIRCUIT DE SIGNALISATION
725
726
724
723
721
722
BG

BV
+ BP CIRCUIT DE COMMANDE
713
711
S
R
712
71
BP
Q

BRZ

BS

7 CIRCUIT DE SURVEILLANCE

## FIG.20

## FIG.21

## FIG.22

# FIG.23

# FIG.24

# FIG.25

0 136 237